# EUROPEAN PATENT APPLICATION

(11) **EP 4 514 091 A1**
(43) Date of publication of application: **26.02.2025**
(21) Application number: 24183791.3
(22) Date of filing: 21.06.2024
(51) Int. Cl.: H10B 41/27, H01L 23/00, H10B 41/50, H10B 43/27, H10B 43/50

(54) **SEMICONDUCTOR MEMORY DEVICES, METHODS FOR FABRICATING THE SAME AND ELECTRONIC SYSTEMS INCLUDING THE SAME**

(30) Priority: 25.08.2023 KR 20230112031
(71) Applicant: Samsung Electronics Co., Ltd., Suwon-si, Gyeonggi-do 16677 (KR)
(72) Inventor: LEE, Min Yong, 16677 Suwon-si (KR); LEE, Se Hoon, 16677 Suwon-si (KR); KIM, Jun Hyoung, 16677 Suwon-si (KR); KIM, Ji Young, 16677 Suwon-si (KR); SUNG, Suk Kang, 16677 Suwon-si (KR)
(74) Representative: Marks & Clerk LLP

(57) **Abstract**

A semiconductor memory device may include a cell substrate including a first surface and a second surface opposite to the first surface, and a landing pattern including a third surface and a fourth surface opposite to the third surface, with the landing pattern spaced apart from the cell substrate in a horizontal direction. The semiconductor memory device may include a plurality of gate electrodes sequentially stacked on the first surface and the third surface, a channel structure on the cell substrate, the channel structure extending vertically and intersecting the plurality of gate electrodes, an upper insulating film covering the second surface and the fourth surface, an input/output pad on the upper insulating film, the input/output pad overlapping at least a portion of the plurality of gate electrodes in the vertical direction, and a support contact extending through the upper insulating film and connecting the landing pattern and the input/output pad.

## Description

### FIELD

The present disclosure relates to semiconductor memory devices, methods for fabricating the same, and electronic systems including the same, and more particularly, to semiconductor memory devices including memory cells that are three-dimensionally arranged, methods for fabricating the same, and electronic systems including the same.

### BACKGROUND

As electronic systems increasingly use semiconductor memory devices that may store high amounts of data, methods capable of increasing data storage capacity of semiconductor memory devices are being studied. One of the methods that has been proposed for increasing the data storage capacity of the semiconductor memory devices provides a semiconductor memory device including memory cells that are three-dimensionally arranged instead of memory cells that are two-dimensionally arranged.

### SUMMARY

Aspects of the present disclosure provide semiconductor memory devices with an improved degree of integration.

Aspects of the present disclosure also provide methods for fabricating semiconductor devices with an improved degree of integration.

Aspects of the present disclosure also provide electronic systems including semiconductor devices with an improved degree of integration.

However, aspects of the present disclosure are not restricted to those set forth herein. The above and other aspects of the present disclosure will become more apparent to those of ordinary skill in the art to which the present disclosure pertains by referencing the detailed description of the present disclosure given below.

According to some aspects of the present disclosure, there is provided a semiconductor memory device comprising a cell substrate including a first surface and a second surface opposite to the first surface, a landing pattern including a third surface and a fourth surface opposite to the third surface, the landing pattern spaced apart from the cell substrate in a horizontal direction, a plurality of gate electrodes sequentially stacked on the first surface and the third surface, a channel structure on the cell substrate, the channel structure extending in a vertical direction that intersects the first surface and the channel structure intersecting the plurality of gate electrodes, an upper insulating film that covers the second surface and the fourth surface, an input/output pad on the upper insulating film, the input/output pad overlapping at least a portion of the plurality of gate electrodes in the vertical direction (i.e. the input/output pad overlapping at least a portion of the plurality of gate electrodes when viewed in the vertical direction), and a support contact that extends through the upper insulating film and connects the landing pattern and the input/output pad.

According to some aspects of the present disclosure, there is provided a semiconductor memory device comprising a peripheral circuit structure including a peripheral circuit substrate and a peripheral circuit element on the peripheral circuit substrate, and a cell structure stacked on the peripheral circuit structure, wherein the cell structure includes a cell substrate including a first surface that faces the peripheral circuit structure and a second surface opposite to the first surface, a landing pattern including a third surface that faces the peripheral circuit structure and a fourth surface opposite to the third surface, the landing pattern spaced apart from the cell substrate in a horizontal direction, a stacked structure including a plurality of mold insulating films and a plurality of gate electrodes alternately stacked on the first surface and the third surface, a channel structure that extends in a vertical direction that intersects the first surface, the channel structure extending through the stacked structure, an input/output pad on the second surface and the fourth surface, the input/output pad overlapping at least a portion of the stacked structure in the vertical direction (i.e. the input/output pad overlapping at least a portion of the stacked structure when viewed in the vertical direction), a contact plug that extends in the vertical direction and electrically connects the peripheral circuit element and the input/output pad, an upper insulating film interposed between the cell substrate and the input/output pad and between the landing pattern and the input/output pad, and a support contact that extends through the upper insulating film and connects the landing pattern and the input/output pad.

According to some aspects of the present disclosure, there is provided a method for fabricating a semiconductor memory device, the method comprising forming a plurality of gate electrodes that are sequentially stacked on a base substrate, forming a channel structure that intersects the plurality of gate electrodes, forming a preliminary substrate that replaces the base substrate, patterning the preliminary substrate to form a cell substrate connected to the channel structure and a landing pattern spaced apart from the cell substrate, forming an upper insulating film covering the cell substrate and the landing pattern in a horizontal direction, forming a support contact extending through the upper insulating film and connected to the landing pattern, and forming an input/output pad connected to the support contact, on the upper insulating film, with at least a portion of the input/output pad overlapping a portion of the plurality of gate electrodes.

According to some aspect of the present disclosure, there is provided an electronic system comprising a main board, a semiconductor memory device including a peripheral circuit structure and a cell structure sequentially stacked on the main board, and a controller on the main board, the controller electrically connected to the semiconductor memory device, wherein the cell structure includes a cell substrate including a first surface and a second surface opposite to the first surface, a landing pattern including a third surface and a fourth surface opposite to the third surface, the landing pattern spaced apart from the cell substrate in a horizontal direction, a plurality of gate electrodes sequentially stacked on the first surface and the third surface, a channel structure on the cell substrate, the channel structure extending in a vertical direction that intersects the first surface, the channel structure intersecting the plurality of gate electrodes, an upper insulating film that covers the second surface and the fourth surface, an input/output pad on the upper insulating film, the input/output pad overlapping at least a portion of the plurality of gate electrodes in the vertical direction (i.e. the input/output pad overlapping at least a portion of the plurality of gate electrodes when viewed in the vertical direction) and electrically connected to the controller, and a support contact that extends through the upper insulating film and connects the landing pattern with the input/output pad.

At least some of the above and other features of the invention are set out in the claims.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is a block diagram for describing a semiconductor memory device according to some embodiments.
FIG. 2 is a circuit diagram for describing a semiconductor memory device according to some embodiments.
FIG. 3 is a schematic layout diagram for describing a semiconductor memory device according to some embodiments.
FIG. 4 is a layout diagram for describing area S1 of FIG. 3.
FIG. 5 is a cross-sectional view taken along line A-A of FIG. 4.
FIG. 6 is an enlarged view for describing area R1 of FIG. 5.
FIG. 7 is an enlarged view for describing area R2 of FIG. 5.
FIGS. 8 and 9 are cross-sectional views for describing a semiconductor memory device according to some embodiments.
FIG. 10 is a layout diagram for describing a semiconductor memory device according to some embodiments.
FIG. 11 is a cross-sectional view taken along line B-B of FIG. 10.
FIG. 12 is a layout diagram for describing a semiconductor memory device according to some embodiments.
FIG. 13 is a cross-sectional view taken along line C-C of FIG. 12.
FIG. 14 is a layout diagram for describing a semiconductor memory device according to some embodiments.
FIG. 15 is a cross-sectional view taken along line D-D of FIG. 14.
FIGS. 16 to 18 are various layout diagrams for describing a semiconductor memory device according to some embodiments.
FIG. 19 is a schematic layout diagram for describing the semiconductor memory device according to some embodiments.
FIG. 20 is a layout diagram for describing area S2 of FIG. 19.
FIG. 21 is a cross-sectional view taken along line E-E of FIG. 20.
FIG. 22 is a layout diagram for describing a semiconductor memory device according to some embodiments.
FIG. 23 is a cross-sectional view taken along line F-F of FIG. 22.
FIGS. 24 and 25 are various layout diagrams for describing a semiconductor memory device according to some embodiments.
FIGS. 26 to 37 are intermediate step views for describing a method for fabricating a semiconductor memory device according to some embodiments.
FIG. 38 is a block diagram for describing an electronic system according to some embodiments.
FIG. 39 is a perspective view for describing an electronic system according to some embodiments.
FIG. 40 is a schematic cross-sectional view taken along line I-I of FIG. 39.

### DETAILED DESCRIPTION

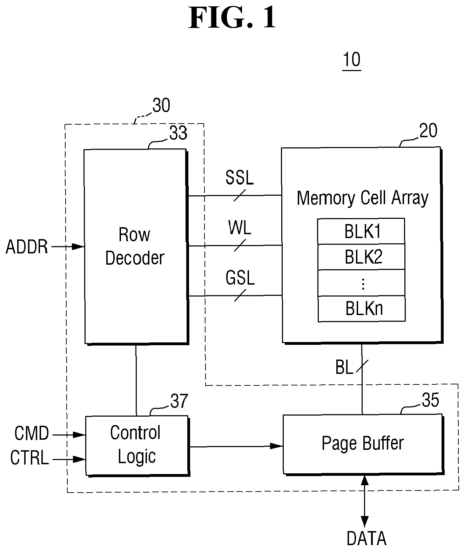

Hereinafter, a semiconductor memory device according to some embodiments will be described with reference to FIGS. 1 to 25.

FIG. 1 is a block diagram for describing a semiconductor memory device 10 according to some embodiments.

A memory cell array 20 may include a plurality of memory cell blocks BLK1 to BLKn. Each of the memory cell blocks BLK1 to BLKn may include a plurality of memory cells, which are not shown in FIG. 1. The memory cell array 20 may be connected to a peripheral circuit 30 through at least one bit line BL, at least one word line WL, at least one string select line SSL, and at least one ground select line GSL. Specifically, the memory cell blocks BLK1 to BLKn may be connected to a row decoder 33 through the word lines WL, the string select lines SSL, and the ground select lines GSL. In addition, the memory cell blocks BLK1 to BLKn may be connected to a page buffer 35 through the bit lines BL.

The peripheral circuit 30 may receive an address ADDR, a command CMD, and a control signal CTRL from an external device or component that is outside of the semiconductor memory device 10 (and not shown in FIG. 1), and the peripheral circuit 30 may transmit and receive data DATA to and from an external device of the semiconductor memory device 10 (which may be the same as or different from the external device or component providing the peripheral circuit 30 with the address ADDR, command CMD, and control signal CTRL). The peripheral circuit 30 may include a control logic 37, a row decoder 33, and a page buffer 35. Although not illustrated in FIG. 1, the peripheral circuit 30 may further include various sub-circuits such as an input/output circuit, a voltage generating circuit configured to generate various voltages used in operations of the semiconductor memory device 10, and an error correction circuit configured to correct an error in data DATA read from the memory cell array 20.

The control logic 37 may be connected to the row decoder 33, the input/output circuit, and the voltage generating circuit. The control logic 37 may be configured to control an overall operation of the semiconductor memory device 10. The control logic 37 may generate a variety of internal control signals used in the semiconductor memory device 10 in response to the control signal CTRL. For example, the control logic 37 may adjust a voltage level provided to at least one word line WL and at least one bit line BL when performing a memory operation such as a program operation or an erase operation.

The row decoder 33 may select at least one of the plurality of memory cell blocks BLK1 to BLKn in response to the address ADDR, and may select at least one word line WL, at least one string select line SSL, and at least one ground select line GSL of the selected memory cell blocks BLK1 to BLKn. In addition, the row decoder 33 may transfer a voltage used in performing a memory operation to the word line WL of the selected memory cell blocks BLK1 to BLKn.

The page buffer 35 may be connected to the memory cell array 20 through the bit line BL. The page buffer 35 may operate as a writer driver or a sense amplifier. Specifically, when performing a program operation, the page buffer 35 may operate as the write driver to apply a voltage according to the data DATA to be stored in the memory cell array 20 to the bit line BL. Meanwhile, when performing a read operation, the page buffer 35 may operate as a sense amplifier to sense the data DATA stored in the memory cell array 20.

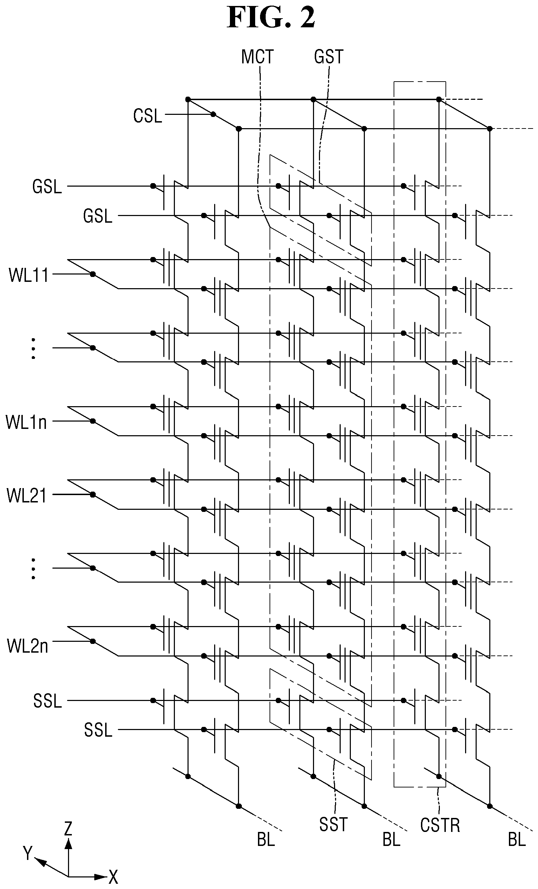

FIG. 2 is a circuit diagram for describing a semiconductor memory device according to some embodiments.

Referring to FIG. 2, a memory cell array (e.g., the memory cell array 20 in FIG. 1) of a semiconductor memory device according to some embodiments may include a common source line CSL, a plurality of bit lines BL, and a plurality of cell strings CSTR.

The plurality of bit lines BL may be two-dimensionally arranged in a plane including a first direction X and a second direction Y. For example, the bit lines BL may each extend in the second direction Y and may be arranged in the first direction X while being spaced apart from each other in the first direction X. Some of the plurality of cell strings CSTR may be connected in parallel to each of the bit lines BL. The cell strings CSTR may be commonly connected to the common source line CSL. That is, the plurality of cell strings CSTR may be between the bit lines BL and the common source line CSL.

Each of the cell strings CSTR may include a ground select transistor GST connected to the common source line CSL, a string select transistor SST connected to the bit line BL, and a plurality of memory cell transistors MCT between the ground select transistor GST and the string select transistor SST. Each of the memory cell transistors MCT may include a data storage element. The ground select transistor GST, the string select transistor SST, and the memory cell transistors MCT may be connected in series.

The common source line CSL may be commonly connected to sources of the ground select transistors GST. In addition, the ground select line GSL, a plurality of word lines WL11 to WL1n and WL21 to WL2n, and the string select line SSL may be between the common source line CSL and the bit line BL. The ground select line GSL may be used as a gate electrode of the ground select transistor GST, the word lines WL11 to WL1n and WL21 to WL2n may be used as gate electrodes of the memory cell transistors MCT, and the string select line SSL may be used as a gate electrode of the string select transistor SST.

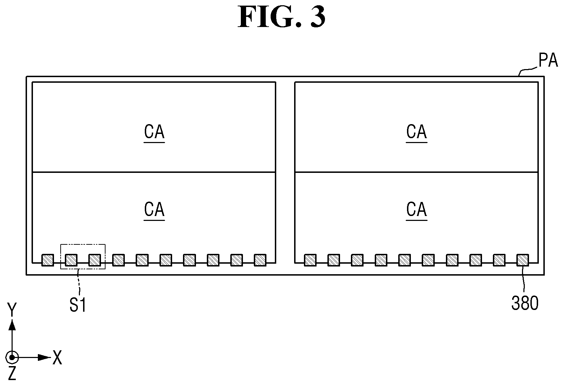

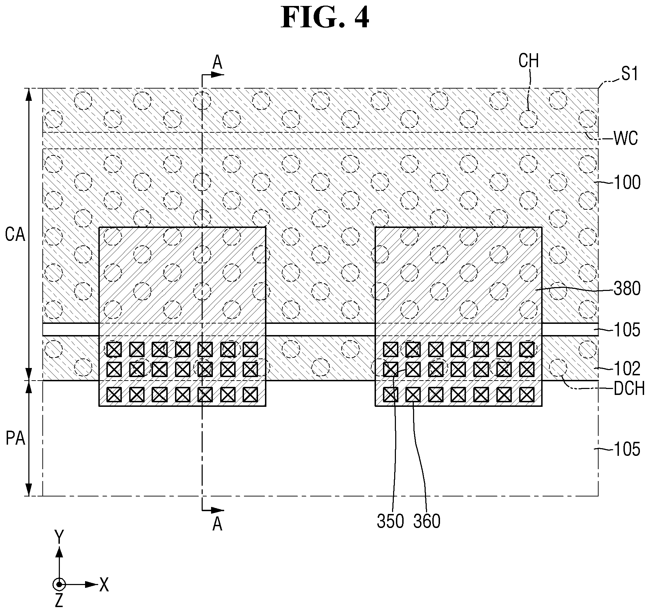

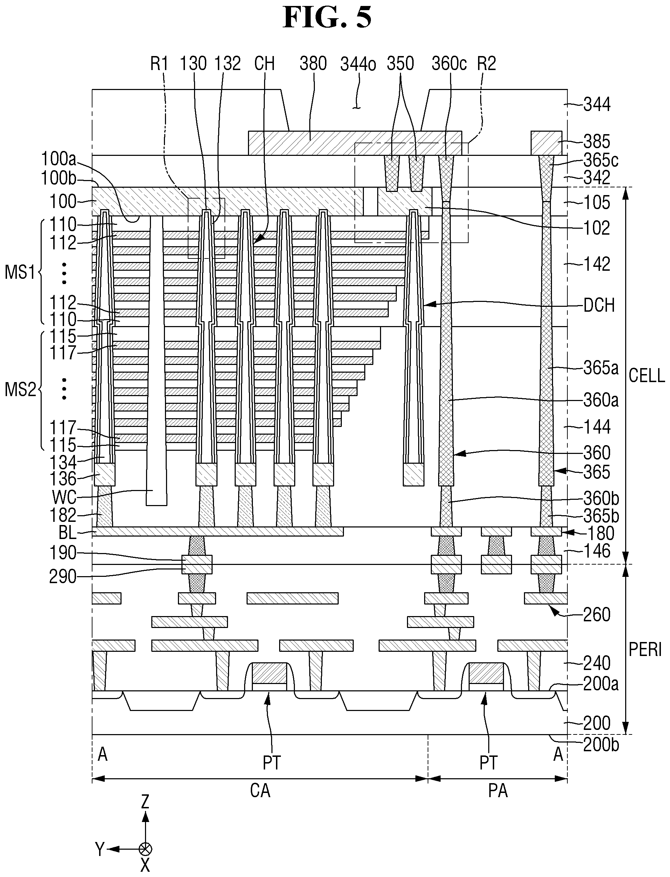

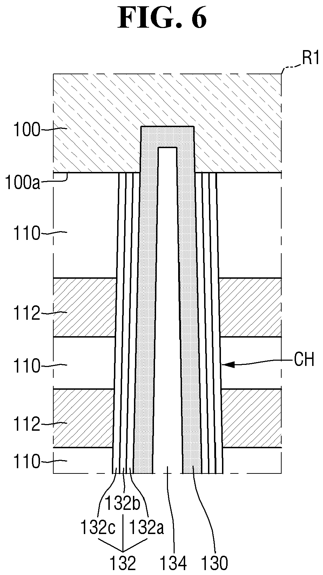

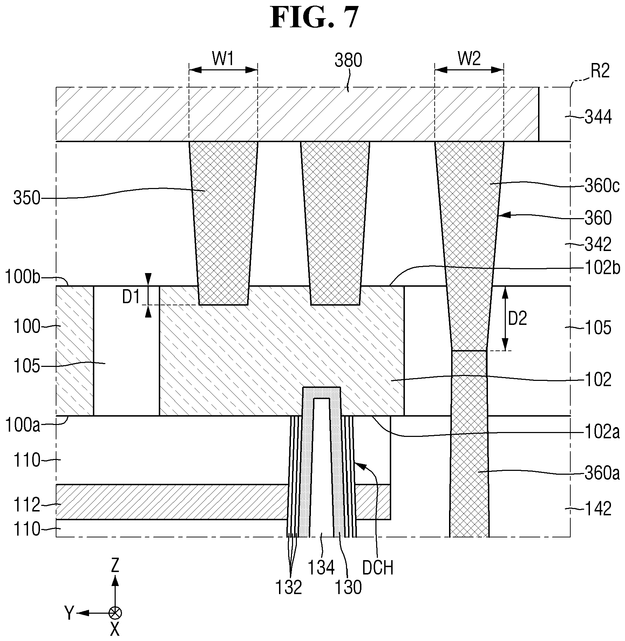

FIG. 3 is a schematic layout diagram for describing a semiconductor memory device according to some embodiments. FIG. 4 is a layout diagram for describing area S1 of FIG. 3. FIG. 5 is a cross-sectional view taken along line A-A of FIG. 4. FIG. 6 is an enlarged view for describing area R1 of FIG. 5. FIG. 7 is an enlarged view for describing area R2 of FIG. 5.

Referring to FIGS. 3 to 7, a semiconductor memory device according to some embodiments includes a cell structure CELL, a peripheral circuit structure PERI, an upper insulating film 342, a support contact 350, and an input/output pad 380.

The cell structure CELL may include a cell array area CA and an external area PA. The memory cell array (e.g., the memory cell array 20 in FIG. 1) including the plurality of memory cells may be formed in the cell array area CA. For example, a cell substrate 100, a channel structure CH, gate electrodes 112 and 117, and a bit line BL, which will be described in greater detail later, may be in the cell array area CA. The external area PA may be a peripheral area that surrounds the cell array area CA. FIG. 3 shows four cell array areas CA that are arranged in a lattice form within the external area PA, but this is only an example, and the number and arrangement of cell array areas CA are not limited to those illustrated in the drawings.

The cell structure CELL may include a cell substrate 100, a landing pattern 102, an insulating substrate 105, stacked structures MS1 and MS2, interlayer insulating films 142 and 144, a channel structure CH, a word line cut area WC, a bit line BL, and a cell wiring structure 180.

The cell substrate 100 may be arranged in the cell array area CA. The cell substrate 100 may include, for example, a semiconductor substrate such as a silicon substrate, a germanium substrate, or a silicon-germanium substrate. Alternatively, the cell substrate 100 may also include a silicon-on-insulator (SOI) substrate or a germanium-on-insulator (GOI) substrate.

The cell substrate 100 may include a first surface 100a and a second surface 100b that are opposite to each other. In the following description, the first surface 100a may be referred to as a front side of the cell substrate 100, and the second surface 100b may also be referred to as a back side of the cell substrate 100.

In some embodiments, the cell substrate 100 may include a conductive material. The conductive material may include, but is not limited to, for example, polysilicon doped with impurities, metal, or metal silicide. For example, the cell substrate 100 may include poly-silicon (poly-Si) doped with N-type impurities (e.g., phosphorus (P), arsenic (As), etc.). The cell substrate 100 may be provided as the common source line (e.g., CSL in FIG. 2) of the semiconductor memory device according to some embodiments.

The insulating substrate 105 may be formed around the cell substrate 100. The insulating substrate 105 may form an insulating area around the cell substrate 100 over the cell array area CA and/or the external area PA. The insulating substrate 105 may include, but is not limited to, for example, at least one of silicon oxide, silicon nitride, silicon oxynitride, and/or silicon carbide.

The landing pattern 102 may be provided in the cell array area CA. The landing pattern 102 may be formed around the cell substrate 100. The landing pattern 102 may be spaced apart from the cell substrate 100. For example, a portion of the insulating substrate 105 may be interposed between the cell substrate 100 and the landing pattern 102. The landing pattern 102 may be provided within the insulating substrate 105 when viewed in plan view, and the landing pattern 102 may be electrically separated from the cell substrate 100. In some embodiments, the landing pattern 102 may be electrically separated from the cell substrate 100 by the insulating substrate 105.

As illustrated in FIG. 7, the landing pattern 102 may include a third surface 102a and a fourth surface 102b that are opposite to each other. The third surface 102a of the landing pattern 102 may face the same direction as the first surface 100a of the cell substrate 100, and the fourth surface 102b of the landing pattern 102 may face the same direction as the second surface 100b of the cell substrate 100. In some embodiments, the third surface 102a of the landing pattern 102 may be coplanar with the first surface 100a of the cell substrate 100. In some embodiments, the fourth surface 102b of the landing pattern 102 may be coplanar with the second surface 100b of the cell substrate 100.

In some embodiments, the landing pattern 102 may be closer to the external area PA than the cell substrate 100. In some embodiments, the landing pattern 102 may extend in length in the first direction X, and may have a greater dimension in the first direction X than in the second direction Y.

In some embodiments, the landing pattern 102 may include a conductive material. The conductive material may include, but is not limited to, for example, polysilicon doped with impurities, metal, or metal silicide. As an example, the landing pattern 102 may include poly-silicon (poly-Si) doped with N-type impurities (e.g., phosphorus (P), arsenic (As), etc.).

In some embodiments, the landing pattern 102 may be formed at the same level as the cell substrate 100. Herein, the term "same level" may refer to or include formation by the same fabricating process. For example, the landing pattern 102 may include the same material as the cell substrate 100. Alternatively, the landing pattern 102 may have the same material composition as the cell substrate 100.

The stacked structures MS 1 and MS2 may be formed on the first surface 100a of the cell substrate 100 and the third surface 102a of the landing pattern 102. The stacked structures MS1 and MS2 may include a plurality of gate electrodes 112 and 117 and a plurality of mold insulating films 110 and 115 stacked on the cell substrate 100 and the landing pattern 102. Each of the gate electrodes 112 and 117 and each of the mold insulating films 110 and 115 may have a layered structure extending in a horizontal direction (e.g., the first direction X and/or the second direction Y) parallel to an upper surface of the cell substrate 100. The gate electrodes 112 and 117 may be sequentially stacked on the cell substrate 100 while being spaced apart from each other by the mold insulating films 110 and 115.

In some embodiments, an edge of each of the gate electrodes 112 and 117 adjacent to the external area PA may be stacked in a stepped shape. For example, edges of the stacked structures MS1 and MS2 adjacent to the external area PA may be patterned in a stepped shape.

In some embodiments, the stacked structures MS1 and MS2 may include a plurality of stacks (e.g., a first stack MS 1 and a second stack MS2) sequentially stacked on the cell substrate 100 and the landing pattern 102. It is illustrated that the number of stacks stacked on the cell substrate 100 and the landing pattern 102 is two, but this is only for convenience of explanation, and in some embodiments the number of stacks stacked on the cell substrate 100 may also be three or more.

The first stack MS1 may include first mold insulating films 110 and first gate electrodes 112 alternately stacked on the cell substrate 100 and the landing pattern 102. In some embodiments, the first gate electrodes 112 may include at least one ground select line (e.g., GSL in FIG. 2) and a plurality of first word lines (e.g., WL1 1 to WL1n in FIG. 2) sequentially stacked on the cell substrate 100 and the landing pattern 102. The number and shape of the first mold insulating films 110 and the first gate electrodes 112 are only examples and are not limited to those illustrated.

The second stack MS2 may include second mold insulating films 115 and second gate electrodes 117 alternately stacked on the first stack MS1. In some embodiments, the second gate electrodes 117 may include a plurality of second word lines (e.g., WL21 to WL2n in FIG. 2) and at least one string select line (e.g., SSL in FIG. 2) sequentially stacked on the first stack MS1. The number and shape of the second mold insulating films 115 and the second gate electrodes 117 are only examples and are not limited to those illustrated.

The gate electrodes 112 and 117 may each include, but are not limited to, a conductive material, for example, a metal such as tungsten (W), cobalt (Co), or nickel (Ni), or a semiconductor material such as silicon. As an example, the gate electrodes 112 and 117 may each include at least one of tungsten (W), molybdenum (Mo), and ruthenium (Ru). As another example, the gate electrodes 112 and 117 may each include polysilicon.

The mold insulating films 110 and 115 may each include, but are not limited to, for example, at least one of silicon oxide, silicon nitride, and silicon oxynitride. As an example, the mold insulating films 110 and 115 may each include a silicon oxide film.

The interlayer insulating films 142 and 144 may be formed on the cell substrate 100, the landing pattern 102, and the insulating substrate 105. The interlayer insulating films 142 and 144 may cover the stacked structures MS1 and MS2. In some embodiments, the interlayer insulating films 142 and 144 may include a first interlayer insulating film 142 and a second interlayer insulating film 144. The first interlayer insulating film 142 may cover the first stack MS1, and the second interlayer insulating film 144 may cover the second stack MS2. The first interlayer insulating film 142 and the second interlayer insulating film 144 may each include, but are not limited to, for example, at least one of silicon oxide, silicon oxynitride, and a low-k material having a dielectric constant lower than that of silicon oxide.

The channel structure CH may be formed on the first surface 100a of the cell substrate 100. The channel structure CH may extend in a vertical direction (hereinafter, referred to as a third direction Z) that intersects the first surface 100a of the cell substrate 100. The channel structure CH may penetrate through or extend through the stacked structures MS1 and MS2. For example, the channel structure CH may have a pillar shape (e.g., a cylindrical shape) extending in length in the third direction Z. Accordingly, the channel structure CH may intersect the plurality of gate electrodes 112 and 117.

In some embodiments, the channel structure CH may be connected to the cell substrate 100. For example, as illustrated, the upper surface of the channel structure CH may be coplanar with the first surface 100a of the cell substrate 100 or may be higher than the first surface 100a of the cell substrate 100. The upper surface of the channel structure CH may extend into the cell substrate 100.

In some embodiments, the plurality of channel structures CH may be arranged in a zigzag shape. For example, as illustrated in FIG. 4, the channel structures CH may be arranged to be staggered with each other in the first direction X and the second direction Y. The channel structures CH may further improve a degree of integration of the semiconductor memory device. The number and arrangement of channel structures CH are only examples and are not limited to those illustrated. In some embodiments, the plurality of channel structures CH may be arranged in a honeycomb shape.

In some embodiments, the channel structure CH may have a step between the first stack MS1 and the second stack MS2. For example, as illustrated in FIG. 5, a side surface of the channel structure CH may have a bending portion such as a step or discontinuity at a boundary between the first stack MS1 and the second stack MS2.

In some embodiments, as illustrated in FIG. 6, each of the channel structures CH may include a semiconductor pattern 130 and an information storage film 132.

The semiconductor pattern 130 may extend in the third direction Z and may intersect the plurality of gate electrodes 112 and 117. It is illustrated that the semiconductor pattern 130 has a cup shape, but this is only an example. For example, the semiconductor pattern 130 may also have various shapes, such as a cylindrical shape, a rectangular shape, and a closely packed pillar shape. The semiconductor pattern 130 may include, but is not limited to, for example, a semiconductor material such as single crystal silicon, polycrystalline silicon, an organic semiconductor material, and a carbon nanostructure.

In some embodiments, the semiconductor pattern 130 may be connected to the cell substrate 100. For example, one end (e.g., an upper end) of the semiconductor pattern 130 may be exposed from the information storage film 132 and connected to the cell substrate 100. In some exemplary embodiments, the semiconductor pattern 130 may penetrate through the first surface 100a of the cell substrate 100. For example, one end (e.g., an upper end) of the semiconductor pattern 130 may protrude more than the information storage film 132. Such a semiconductor pattern 130 may reduce contact resistance by improving a contact area with the cell substrate 100.

The information storage film 132 may be interposed between the semiconductor pattern 130 and each of the gate electrodes 112 and 117. For example, the information storage film 132 may extend along an outer side surface of the semiconductor pattern 130. The information storage film 132 may include, for example, at least one of silicon oxide, silicon nitride, silicon oxynitride, and a high-k material having a dielectric constant higher than that of silicon oxide. The high-k material may include, for example, at least one of aluminum oxide, hafnium oxide, lanthanum oxide, tantalum oxide, titanium oxide, lanthanum hafnium oxide, lanthanum aluminum oxide, or dysprosium scandium oxide, or a combination of two or more thereof, but the present disclosure is not limited thereto.

In some embodiments, the information storage film 132 may be formed as a multi-film. For example, as illustrated in FIG. 6, the information storage film 132 may include a tunnel insulating film 132a, a charge storage film 132b, and a blocking insulating film 132c sequentially stacked on the outer side surface of the semiconductor pattern 130.

The tunnel insulating film 132a may include, for example, silicon oxide or a high-k material (e.g., aluminum oxide (Al₂O₃) or hafnium oxide (HfO₂)) having a dielectric constant that is higher than that of silicon oxide. The charge storage film 132b may include, for example, silicon nitride. The blocking insulating film 132c may include, for example, silicon oxide or a high-k material (e.g., aluminum oxide (Al₂O₃) or hafnium oxide (HfO₂)) having a dielectric constant that is higher than that of silicon oxide.

In some embodiments, the channel structure CH may further include a filling insulating film 134. The filling insulating film 134 may fill or may be within an inner portion of the semiconductor pattern 130 having the cup shape. The filling insulating film 134 may include, but is not limited to, an insulating material, for example, silicon oxide.

In some embodiments, the channel structure CH may further include a channel pad 136. The channel pad 136 may be formed to be connected to the other end (e.g., a lower end) of the semiconductor pattern 130. The channel pad 136 may include, but is not limited to, a conductive material, for example, polysilicon doped with impurities or a metal.

In some embodiments, a dummy channel structure DCH may be formed on the third surface 102a of the landing pattern 102. The dummy channel structure DCH may extend in the third direction Z and penetrate through or extend through at least a portion of the stacked structures MS1 and MS2. When the edges of the stacked structures MS1 and MS2 adjacent to the external area PA are patterned in a step shape, the dummy channel structure DCH may penetrate through or extend through only a portion of the stacked structures MS1 and MS2.

In some embodiments, the dummy channel structure DCH may be connected to the landing pattern 102. For example, as illustrated, an upper surface of the dummy channel structure DCH may be coplanar with the third surface 102a of the landing pattern 102 or may be higher than the third surface 102a of the landing pattern 102. The upper surface of the dummy channel structure DCH may extend into the landing pattern 102.

In some exemplary embodiments, the dummy channel structure DCH may be formed at the same level and by way of the same processes as the channel structure CH. For example, the dummy channel structure DCH may include the semiconductor pattern 130, the information storage film 132, the filling insulating film 134, and the channel pad 136 described above.

It is illustrated that the size (e.g., height and/or width) of the dummy channel structure DCH is the same as that of the channel structure CH, but this is only an example, and the size of the dummy channel structure DCH may be greater or smaller than that of the channel structure CH.

The word line cut area WC may extend in the first direction X and may cut the stacked structures MS1 and MS2. A plurality of word line cut areas WC may each extend in the first direction X, and be arranged along the second direction Y while being spaced apart from each other. The stacked structures MS1 and MS2 may be divided by the word line cut areas WC to form a plurality of memory cell blocks (e.g., BLK1 to BLKn in FIG. 1).

In some embodiments, the word line cut area WC may be filled with an insulating material. The insulating material may include, but is not limited to, for example, at least one of silicon oxide, silicon nitride, and silicon oxynitride.

Each bit line BL may be formed on the stacked structures MS1 and MS2. Each bit line BL may extend in length in the second direction Y and may be connected to the plurality of channel structures CH arranged along the second direction Y. For example, a bit line contact 182 may be connected to the channel pad 136, and may be within the interlayer insulating films 142 and 144. Each bit line BL may be electrically connected to the channel structures CH through the bit line contact 182. The plurality of bit lines BL may each extend in the second direction Y and may be arranged along the first direction X while being spaced apart from each other.

In some exemplary embodiments, each bit line BL may be interposed between the channel structure CH and the peripheral circuit structure PERI.

The cell wiring structure 180 may be formed on the stacked structures MS1 and MS2. For example, a first inter-wiring insulating film 146 may be formed on the interlayer insulating films 142 and 144, and the cell wiring structure 180 may be in the first inter-wiring insulating film 146.

The cell wiring structure 180 may be electrically connected to the plurality of memory cells formed in the cell array area CA. For example, the cell wiring structure 180 may be electrically connected to the bit lines BL. Through this, the cell wiring structure 180 may be electrically connected to the channel structure CH. In addition, although not specifically illustrated, the cell wiring structure 180 may be electrically connected to the cell substrate 100 and each of the gate electrodes 112 and 117. For example, a source contact (not illustrated) extending in the third direction Z and connected to the cell substrate 100, and a plurality of gate contacts (not illustrated) extending in the third direction Z and connected to the corresponding gate electrodes 112 and 117 may be formed. The cell wiring structure 180 may be electrically connected to the source contact and the gate contacts. The number and arrangement of layers of the cell wiring structure 180 illustrated are only examples and are not limited thereto.

The peripheral circuit structure PERI may include a peripheral circuit substrate 200, at least one peripheral circuit element PT, and a peripheral circuit wiring structure 260.

The peripheral circuit substrate 200 may include, for example, a semiconductor substrate such as a silicon substrate, a germanium substrate, or a silicon-germanium substrate. Alternatively, the peripheral circuit substrate 200 may include a silicon-on-insulator (SOI) substrate or a germanium-on-insulator (GOI) substrate.

The peripheral circuit substrate 200 may have a fifth surface 200a and a sixth surface 200b that are opposite to each other. In the following description, the fifth surface 200a may be referred to as a front side of the peripheral circuit substrate 200, and the sixth surface 200b may also be referred to as a back side of the peripheral circuit substrate 200.

The peripheral circuit element PT may be formed on the fifth surface 200a of the peripheral circuit substrate 200. The peripheral circuit element PT may constitute a peripheral circuit (e.g., the peripheral circuit 30 in FIG. 1) that controls the operation of the semiconductor memory device. For example, the peripheral circuit element PT may include a control logic (e.g., the control logic 37 in FIG. 1), a row decoder (e.g., the row decoder 33 in FIG. 1), and a page buffer (e.g., the page buffer 35 in FIG. 1).

The peripheral circuit element PT may include, but is not limited to, for example, a transistor. In some embodiments, the peripheral circuit element PT may include various active elements such as transistors, as well as various passive elements such as capacitors, resistors, and inductors.

The peripheral circuit wiring structure 260 may be formed on the peripheral circuit element PT. For example, a second inter-wiring insulating film 240 may be formed on the fifth surface 200a of the peripheral circuit substrate 200, and the peripheral circuit wiring structure 260 may be within the second inter-wiring insulating film 240. The peripheral circuit wiring structure 260 may be electrically connected to the peripheral circuit element PT. The number and arrangement of layers of the peripheral circuit wiring structure 260 illustrated are only examples and are not limited thereto.

In some embodiments, the cell structure CELL may be stacked on the peripheral circuit structure PERI in the third direction Z. For example, the cell structure CELL may be stacked on the second inter-wiring insulating film 240.

In some embodiments, the first surface 100a of the cell substrate 100 may face the peripheral circuit structure PERI. For example, the first surface 100a of the cell substrate 100 may face the fifth surface 200a of the peripheral circuit substrate 200.

The semiconductor memory device according to some embodiments may have a chip to chip (C2C) structure. The C2C structure may refer to a structure in which an upper chip including the cell structure CELL is fabricated on a first wafer, a lower chip including the peripheral circuit structure PERI is fabricated on a second wafer different from the first wafer, and the upper chip and the lower chip are then connected to each other by a bonding method.

As an example, the bonding method may refer to a method of electrically connecting a first bonding metal 190 formed on the uppermost metal layer of the upper chip (e.g., the chip including the cell structure CELL) and a second bonding metal 290 formed on the uppermost metal layer of the lower chip (e.g., the chip including the peripheral circuit structure PERI). For example, when the first bonding metal 190 and the second bonding metal 290 are formed of copper (Cu), the bonding method may be a Cu-Cu bonding method. However, this is only an example, and the first bonding metal 190 and the second bonding metal 290 may also be formed of various other metals such as aluminum (Al) or tungsten (W).

As the first bonding metal 190 and the second bonding metal 290 are bonded, the cell wiring structure 180 may be electrically connected to the peripheral circuit wiring structure 260. Through this, the bit line BL, each of the gate electrodes 112 and 117, and/or the cell substrate 100 may be electrically connected to the peripheral circuit element PT.

The upper insulating film 342 may be formed on the cell substrate 100, the landing pattern 102, and/or the insulating substrate 105. The upper insulating film 342 may cover the second surface 100b of the cell substrate 100 and the fourth surface 102b of the landing pattern 102. The upper insulating film 342 may include, but is not limited to, for example, at least one of silicon oxide, silicon oxynitride, and a low-k material having a dielectric constant lower than that of silicon oxide. A thickness of the upper insulating film 342 may be, for example, in a range from about 300 nm to about 1,000 nm, but is not limited thereto.

The input/output pad 380 may be formed on the upper insulating film 342. The upper insulating film 342 may be interposed between the cell structure CELL and the input/output pad 380. At least a portion of the input/output pad 380 may overlap the cell array area CA in the third direction Z i.e. at least a portion of the input/output pad 380 may overlap the cell array area CA when viewed in the third direction Z. In some embodiments, the input/output pad 380 may be formed over or extend over the cell array area CA and the external area PA. For example, a portion of the input/output pad 380 may overlap the cell array area CA in the third direction Z, and another portion of the input/output pad 380 may overlap the external area PA in the third direction Z. Specifically, a portion of the input/output pad 380 may overlap the cell array area CA when viewed in the third direction Z, and another portion of the input/output pad 380 may overlap the external area PA when viewed in the third direction Z.

The input/output pad 380 may be electrically connected to the cell structure CELL and/or the peripheral circuit structure PERI. For example, a first contact plug 360 may be formed and may connect the cell wiring structure 180 with the input/output pad 380. For example, the first contact plug 360 may extend in the third direction Z within the external area PA and may penetrate through or extend through the interlayer insulating films 142 and 144, the insulating substrate 105, and the upper insulating film 342. The input/output pad 380 may be electrically connected to the cell wiring structure 180 through the first contact plug 360. The first contact plug 360 may include, but is not limited to, a conductive material, for example, a metal material such as tungsten (W), molybdenum (Mo), ruthenium (Ru), cobalt (Co), or nickel (Ni).

In some embodiments, a plurality of first contact plugs 360 connected to one input/output pad 380 may be formed. It is illustrated in FIG. 4 that seven first contact plugs 360 are arranged along the first direction X with respect to one input/output pad 380, but this is only an example, and the number and arrangement of the first contact plugs 360 are not limited to those illustrated.

In some embodiments, the first contact plug 360 may be spaced apart from the landing pattern 102 in a horizontal direction (e.g., the first direction X and/or the second direction Y).

In some embodiments, the first contact plug 360 may include a first plug pattern 360a, a second plug pattern 360b, and a third plug pattern 360c. The first plug pattern 360a may be formed on the side surfaces of the stacked structures MS1 and MS2. The second plug pattern 360b may connect the cell wiring structure 180 and the first plug pattern 360a. The third plug pattern 360c may connect the input/output pad 380 and the first plug pattern 360a.

In some embodiments, a width of the first plug pattern 360a may decrease toward the third plug pattern 360c. In some embodiments, a width of the second plug pattern 360b may decrease toward the first plug pattern 360a. In some embodiments, a width of the third plug pattern 360c may decrease toward the first plug pattern 360a.

In some embodiments, the first plug pattern 360a and the third plug pattern 360c may be in contact with each other within the insulating substrate 105. For example, an interface between the first plug pattern 360a and the third plug pattern 360c may be within the insulating substrate 105.

The support contact 350 may be formed on the landing pattern 102. The support contact 350 may extend in the third direction Z. The support contact 350 may connect the landing pattern 102 and the input/output pad 380 by penetrating through the upper insulating film 342. The landing pattern 102 and the support contact 350 may form a load distribution structure that supports the input/output pad 380 on the cell array area CA. The support contact 350 may have a pillar shape (e.g., a cylindrical shape, a square pillar shape, or another polygonal pillar shape) extending in length the third direction Z. A width W1 of the support contact 350 may be about 200 nm to about 500 nm, but is not limited thereto.

In some embodiments, a plurality of support contacts 350 connected to one input/output pad 380 may be formed. It is illustrated in FIG. 4 that 14 support contacts 350 are arranged in a lattice form with respect to one input/output pad 380, but this is only an example, and the number and arrangement of support contacts 350 are not limited to those illustrated.

In some embodiments, the width of each support contact 350 in one or more horizontal directions may decrease toward the landing pattern 102. This may result from an etching process for forming the support contact 350 that is performed on the fourth surface 102b of the landing pattern 102.

In some embodiments, a lower surface of each support contact 350 may be formed below the fourth surface 102b of the landing pattern 102. For example, the lower surface of each support contact 350 may be formed between the third surface 102a of the landing pattern 102 and the fourth surface 102b of the landing pattern 102. In this case, the support contact 350 may be supported (e.g., supported strongly) by the landing pattern 102 to form a more effective load distribution structure.

In some embodiments, each support contact 350 may be formed at the same time or step, or as a result of the same process, as the third plug pattern 360c. For example, the support contact 350 may include the same conductive material as the third plug pattern 360c. Alternatively, the support contact 350 may have the same material composition as the third plug pattern 360c.

In some embodiments, the support contact 350 may be formed to be shallower than the third plug pattern 360c of the first contact plug 360. For example, as illustrated in FIG. 7, based on the fourth surface 102b of the landing pattern 102, (or with using the fourth surface 102b as a reference) a depth D1 at which the support contact 350 is formed may be smaller than a depth D2 at which the third plug pattern 360c is formed. This may result from an etching process for forming the support contact 350 and the third plug pattern 360c being performed on different materials.

It is illustrated that the width W1 of the support contact 350 and the width W2 of the landing pattern 102 are the same, but this is only an example, and the width W1 of the support contact 350 and the width W2 of the landing pattern 102 may also be different from each other.

In some embodiments, the capping insulating film 344 may be formed on the upper insulating film 342. The capping insulating film 344 may include a pad opening 344o exposing at least a portion of the input/output pad 380. The input/output pad 380 may be electrically connected to an external device, etc. through the pad opening 344o.

In some embodiments, an external contact structure 365 and an external pad 385 may be formed in the external area PA. The external pad 385 may be formed on the upper insulating film 342 and may be spaced apart from the input/output pad 380. The external contact structure 365 may connect the cell wiring structure 180 and the external pad 385. For example, the external contact structure 365 may extend in the third direction Z to penetrate through or extend through the interlayer insulating films 142 and 144, the insulating substrate 105, and the upper insulating film 342.

The external pad 385 and the external contact structure 365 may be arranged at an edge of the external area PA. For example, the external pad 385 and the external contact structure 365 may be spaced further apart from the cell array area CA than the input/output pad 380 and the first contact plug 360. The external pad 385 and the external contact structure 365 may form a crack detection circuit (CDC) of the semiconductor memory device according to some embodiments.

In some embodiments, the external contact structure 365 may include a first contact pattern 365a, a second contact pattern 365b, and a third contact pattern 365c. The first contact pattern 365a may be formed on the side surfaces of the stacked structures MS1 and MS2. The second contact pattern 365b may connect the cell wiring structure 180 and the first contact pattern 365a. The third contact pattern 365c may connect the external pad 385 and the first contact pattern 365a.

In order to improve the degree of integration of semiconductor memory devices, a so-called pad on cell structure has been proposed in which at least a portion of the input/output pad 380 overlaps the cell array area CA. However, the pad on cell structure may present problems, such as when structures (e.g., the stacked structures MS1 and MS2, etc.) of the cell array area CA that are below the input/output pad 380 are damaged or destroyed due to pressure applied during the bonding process (e.g., wire bonding process) to the input/output pad 380. In addition, in the pad on cell structure, as at least a portion of the input/output pad 380 overlaps the cell array area CA, a parasitic capacitance may be generated between the input/output pad 380 and the electrical structures (e.g., the cell substrate 100 and/or the gate electrodes 112 and 117) of the cell array area CA adjacent to the input/output pad 380, and the parasitic capacitance may result in deterioration in the performance of the semiconductor memory device.

The semiconductor memory device according to some exemplary embodiments may protect (e.g., protect effectively) structures (e.g., the stacked structures MS1 and MS2, etc.) that are in the cell array area CA using the landing pattern 102 and the support contact 350. Specifically, as described above, the landing pattern 102 may be in the cell array area CA, and the support contact 350 may connect the landing pattern 102 and the input/output pad 380 by penetrating through or extending through the upper insulating film 342. The landing pattern 102 and the support contact 350 may form a load distribution structure for the pressure applied to the input/output pad 380 by supporting the input/output pad 380 on the cell array area CA. Consequently, a semiconductor memory device with the improved degree of integration may be provided using an effective pad on cell structure.

In some embodiments, the landing pattern 102 may include a different material than cell substrate 100.

As an example, the cell substrate 100 may include polysilicon doped with impurities, and the landing pattern 102 may include a material with higher mechanical strength than the cell substrate 100, for example, a metal material. In this case, the support contact 350 may be supported (e.g., supported strongly) by the landing pattern 102 to form a more effective load distribution structure.

As another example, the cell substrate 100 may include polysilicon doped with impurities, and the landing pattern 102 may include an insulating material such as silicon oxide. In this case, as parasitic capacitance between the cell substrate 100 and the landing pattern 102 is at least partially reduced, a semiconductor memory device with improved performance may be provided.

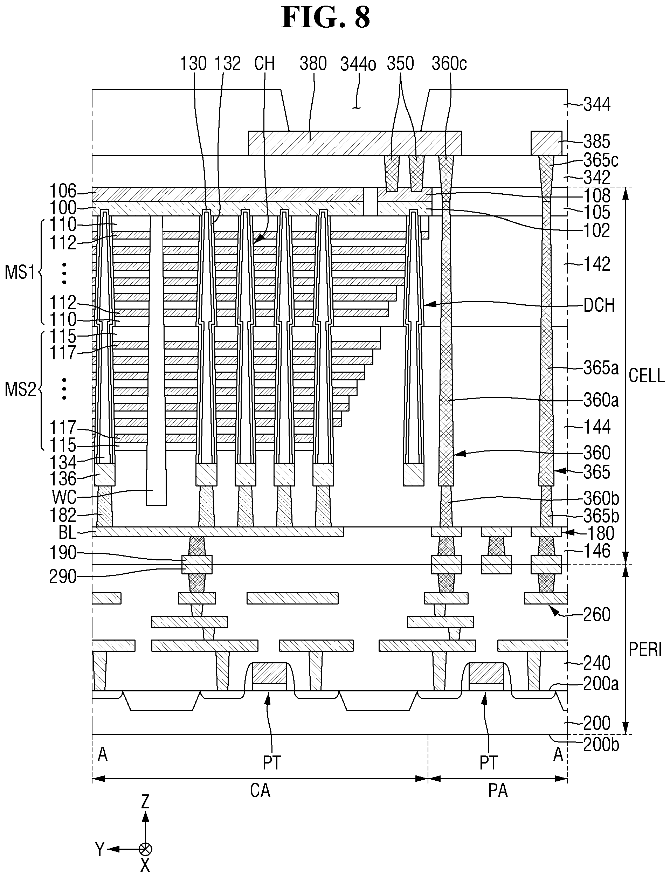

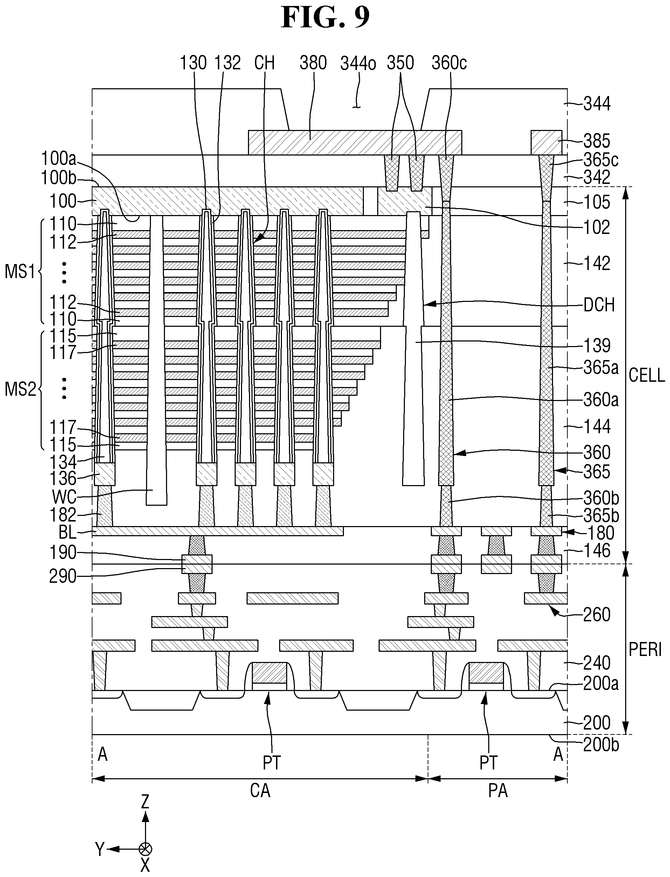

FIGS. 8 and 9 are cross-sectional views for describing a semiconductor memory device according to some embodiments. For convenience of explanation, portions overlapping those described above with reference to FIGS. 1 to 7 will be only briefly described or description thereof will be omitted.

Referring to FIGS. 3, 4, and 8, the semiconductor memory device according to some exemplary embodiments may further include a first conductive plate 106 and a second conductive plate 108.

The first conductive plate 106 may be formed on the cell substrate 100. The first conductive plate 106 may be interposed between the cell substrate 100 and the upper insulating film 342. The first conductive plate 106 may be electrically connected to the cell substrate 100. For example, the first conductive plate 106 may be in contact with an upper surface of the cell substrate 100. The first conductive plate 106 may include, but is not limited to, a conductive material, for example, a metal such as tungsten (W), cobalt (Co), nickel (Ni), or metal silicide. This first conductive plate 106 may be used to reduce electrical resistance of the common source line (e.g., CSL in FIG. 2) that is or includes the cell substrate 100.

The second conductive plate 108 may be formed on the landing pattern 102. The second conductive plate 108 may be interposed between the landing pattern 102 and the upper insulating film 342. The second conductive plate 108 may be electrically connected to the landing pattern 102. For example, the second conductive plate 108 may be in contact with an upper surface of the landing pattern 102. The second conductive plate 108 may include, but is not limited to, a conductive material, for example, a metal such as tungsten (W), cobalt (Co), nickel (Ni), or metal silicide.

The support contact 350 may be formed on the second conductive plate 108. The support contact 350 may connect the second conductive plate 108 and the input/output pad 380 and may penetrate through or extend through the upper insulating film 342. The landing pattern 102, the second conductive plate 108, and the support contact 350 may form a load distribution structure that supports the input/output pad 380 on the cell array area CA.

In some embodiments, the second conductive plate 108 may be formed at the same time or step, or as a result of the same process, as the first conductive plate 106. For example, the second conductive plate 108 may include the same conductive material as the first conductive plate 106. Alternatively, the second conductive plate 108 may have the same material composition as the first conductive plate 106.

Referring to FIGS. 3, 4, and 9, in the semiconductor memory device according to some embodiments, the dummy channel structure DCH may be formed at a different time or step, or as a result of a different process, from the channel structure CH.

For example, the dummy channel structure DCH may include a different material from the channel structure CH. In some embodiments, the dummy channel structure DCH may include an insulating pattern 139. The insulating pattern 139 may include, but is not limited to, for example, at least one of silicon oxide, silicon nitride, and silicon oxynitride. As an example, the insulating pattern 139 may include silicon oxide. In this case, as parasitic capacitance is prevented from occurring between the stacked structures MS1 and MS2 and the dummy channel structure DCH, a semiconductor memory device with additionally improved performance may be provided.

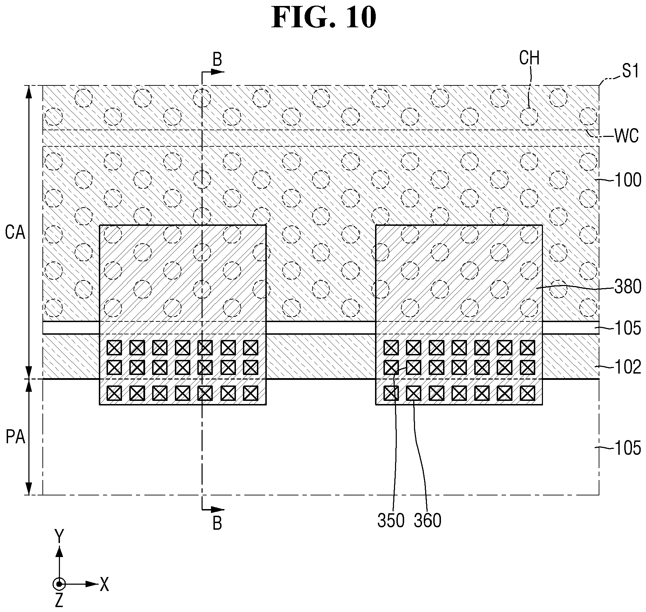

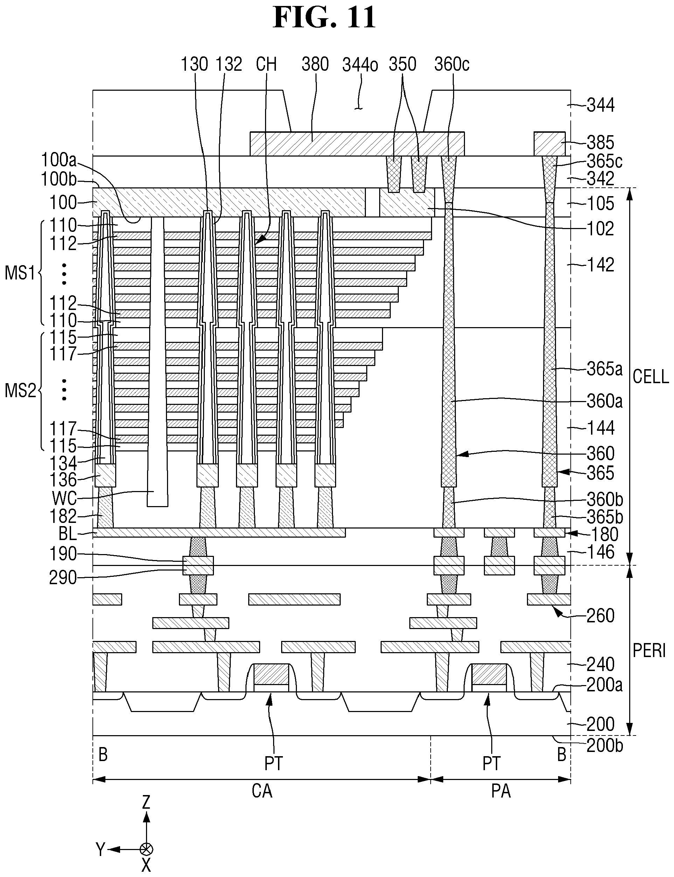

FIG. 10 is a layout diagram for describing a semiconductor memory device according to some embodiments. FIG. 11 is a cross-sectional view taken along line B-B of FIG. 10. For convenience of explanation, portions overlapping those described above with reference to FIGS. 1 to 7 will be only briefly described or a description thereof will be omitted.

Referring to FIGS. 3, 10, and 11, the semiconductor memory device according to some embodiments may not include the dummy channel structure DCH described above using FIGS. 3 to 7. In this case, as parasitic capacitance is prevented from occurring between the stacked structures MS 1 and MS2 and the dummy channel structure DCH, a semiconductor memory device with additionally improved performance may be provided.

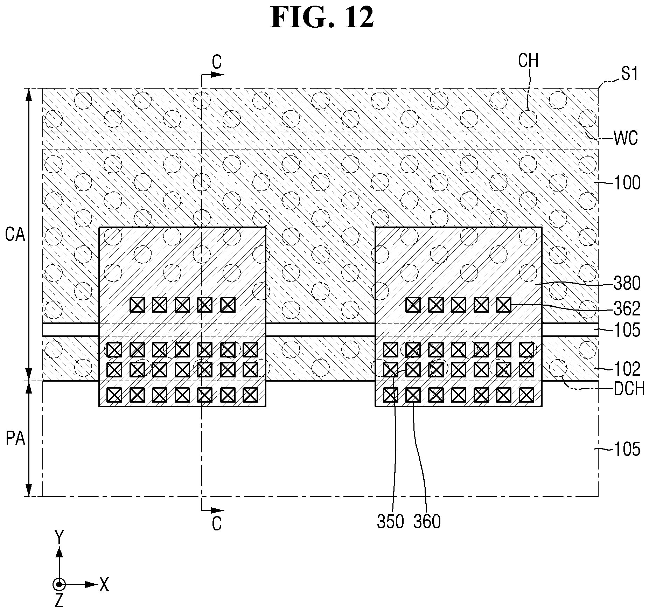

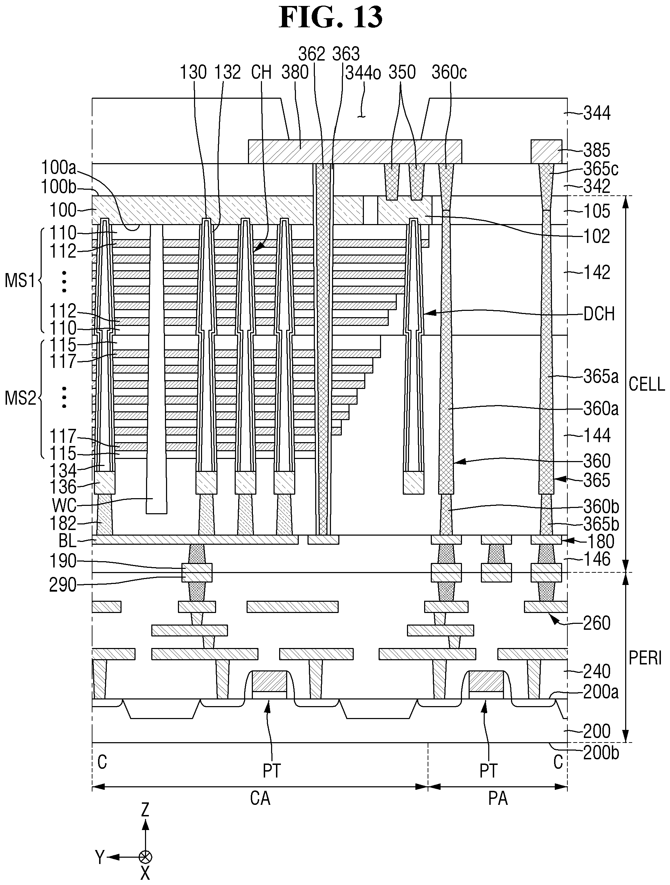

FIG. 12 is a layout diagram for describing a semiconductor memory device according to some embodiments. FIG. 13 is a cross-sectional view taken along line C-C of FIG. 12. For convenience of explanation, portions overlapping those described above with reference to FIGS. 1 to 7 will be only briefly described or a description thereof will be omitted.

Referring to FIGS. 3, 12, and 13, the semiconductor memory device according to some embodiments may further include a second contact plug 362.

The second contact plug 362 may be provided in the cell array area CA. The second contact plug 362 may connect the cell wiring structure 180 and the input/output pad 380. For example, the second contact plug 362 may extend in length in the third direction Z within the cell array area CA and may penetrate through or extend through the interlayer insulating films 142 and 144, the stacked structures MS1 and MS2, the cell substrate 100, and the upper insulating film 342. The input/output pad 380 may be electrically connected to the cell wiring structure 180 through the first contact plug 360 and the second contact plug 362. The second contact plug 362 may include, but is not limited to, a conductive material, for example, a metal material such as tungsten (W), molybdenum (Mo), ruthenium (Ru), cobalt (Co), or nickel (Ni).

In some embodiments, an insulating spacer 363 extending along a side surface of the second contact plug 362 may be formed. For example, the insulating spacer 363 may surround the side surface of the second contact plug 362. The insulating spacer 363 may include, but is not limited to, for example, at least one of silicon oxide, silicon nitride, and silicon oxynitride. The insulating spacer 363 may electrically separate the second contact plug 362 from the cell substrate 100 and the stacked structures MS1 and MS2.

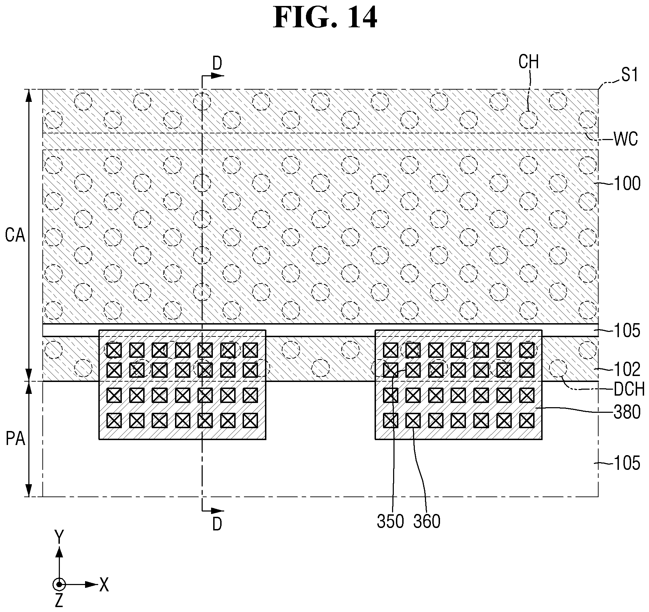

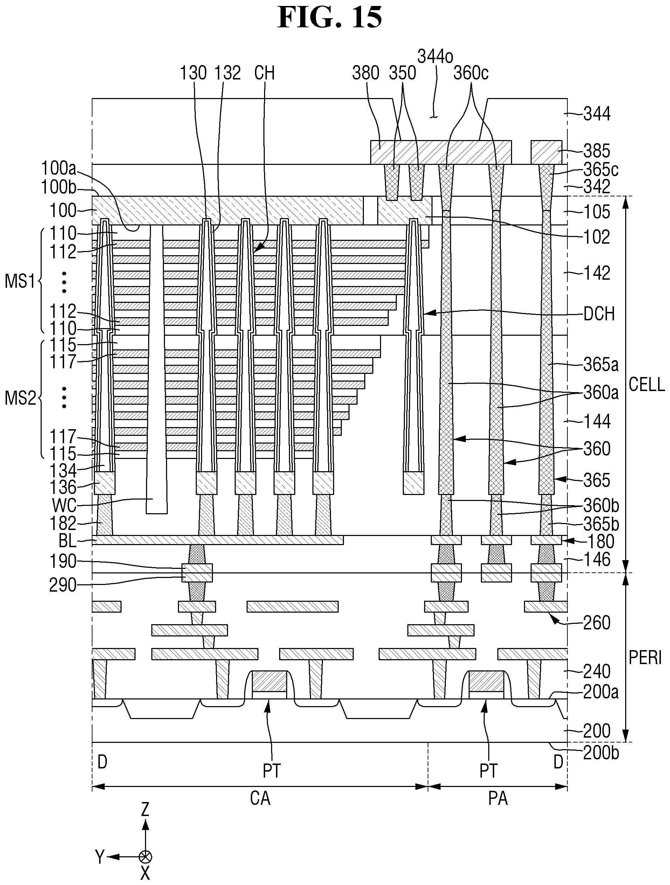

FIG. 14 is a layout diagram for describing a semiconductor memory device according to some exemplary embodiments. FIG. 15 is a cross-sectional view taken along line D-D of FIG. 14. For convenience of explanation, portions overlapping those described above with reference to FIGS. 1 to 7 will be only briefly described or a description thereof will be omitted.

Referring to FIGS. 3, 14, and 15, in the semiconductor memory device according to some embodiments, the input/output pad 380 may not overlap the cell substrate 100.

For example, the input/output pad 380 may be formed over the landing pattern 102 and the external area PA and may not overlap the cell substrate 100 in the third direction Z i.e. the input/output pad 380 may be formed over the landing pattern 102 and the external area PA and may not overlap the cell substrate 100 when viewed in the third direction Z. In some embodiments, as an overlapping area between the input/output pad 380 and the external area PA is expanded, a greater number of first contact plugs 360 may be provided.

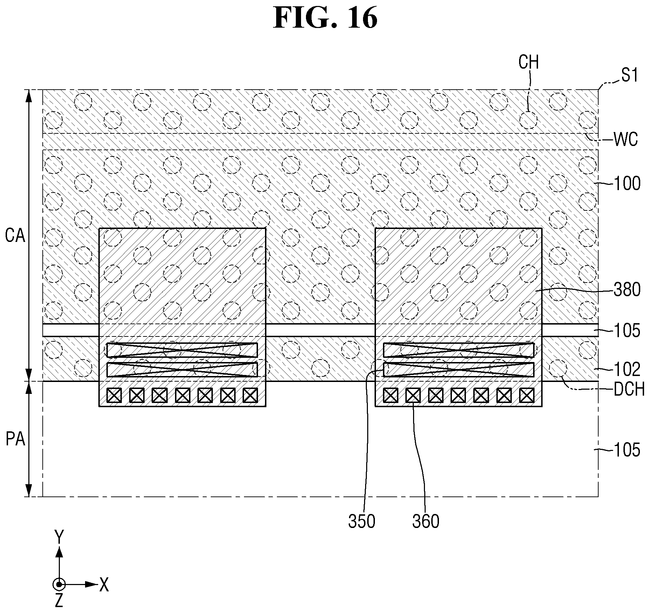

FIGS. 16 to 18 are various layout diagrams for describing a semiconductor memory device according to some embodiments. For convenience of explanation, portions overlapping those described above with reference to FIGS. 1 to 15 will be only briefly described or a description thereof will be omitted.

Referring to FIGS. 3 and 16, in the semiconductor memory device according to some embodiments, the support contact 350 may extend to be relatively long in the first direction X.

For example, one support contact 350 may overlap a plurality of first contact plugs 360 in the second direction Y i.e. when viewed in the second direction Y. Stated differently, one support contact 350 may be greater in length in a horizontal direction (e.g., the first direction X) than a first of the plurality of first contact plugs 360 in the same horizontal direction. It is illustrated in FIG. 16 that two support contacts 350 are arranged along the second direction Y with respect to one input/output pad 380, but this is only an example, and the number and arrangement of support contacts 350 are not limited to those illustrated.

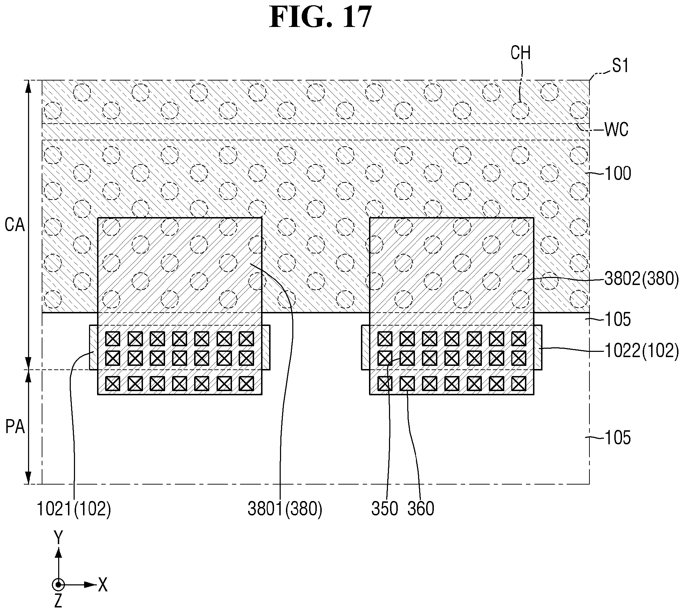

Referring to FIGS. 3 and 17, the semiconductor memory device according to some embodiments may include a plurality of landing patterns 102 corresponding to a plurality of input/output pads 380.

For example, the input/output pad 380 may include a first input/output pad 3801 and a second input/output pad 3802 arranged along the first direction X. In addition, for example, the landing pattern 102 may include a first landing pattern 1021 and a second landing pattern 1022 arranged along the first direction X. The first landing pattern 1021 may overlap the first input/output pad 3801 in the third direction Z, and the second landing pattern 1022 may overlap the second input/output pad 3802 in the third direction Z. Specifically, the first landing pattern 1021 may overlap the first input/output pad 3801 when viewed in the third direction Z, and the second landing pattern 1022 may overlap the second input/output pad 3802 when viewed in the third direction Z. The support contact 350 may connect the first landing pattern 1021 and the first input/output pad 3801, and may connect the second landing pattern 1022 and the second input/output pad 3802. In some embodiments, the first landing pattern 1021 and the second landing pattern 1022 may each extend in length in the second direction Y.

It is illustrated in FIG. 17 that 14 support contacts 350 are arranged in a lattice form with respect to each of the first landing pattern 1021 and the second landing pattern 1022, but this is only an example, and the number and arrangement of support contacts 350 are not limited to those illustrated.

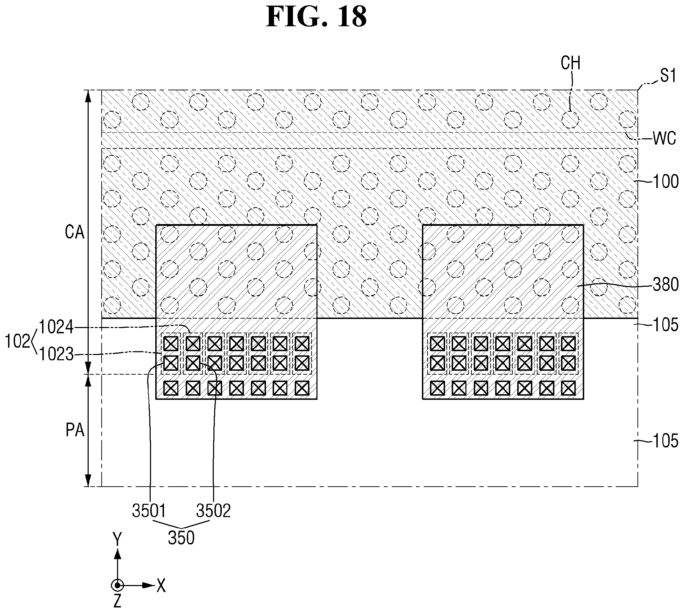

Referring to FIGS. 3 and 18, the semiconductor memory device according to some embodiments may include a plurality of landing patterns 102 corresponding to one input/output pad 380.

For example, the support contact 350 may include a first support contact 3501 and a second support contact 3502 connected to one input/output pad 380. In addition, for example, the landing pattern 102 may include a third landing pattern 1023 and a fourth landing pattern 1024 overlapping one input/output pad 380. The first support contact 3501 may connect the third landing pattern 1023 and the input/output pad 380, and the second support contact 3502 may connect the fourth landing pattern 1024 and the input/output pad 380.

It is illustrated in FIG. 18 that two support contacts 350 are arranged along the second direction Y with respect to each of the third landing pattern 1023 and the fourth landing pattern 1024, but this is only an example, and the number and arrangement of support contacts 350 are not limited to those illustrated.

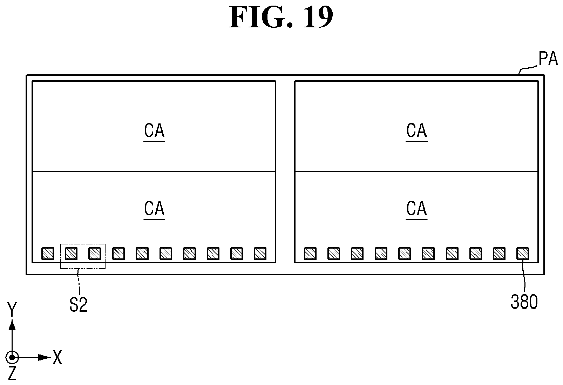

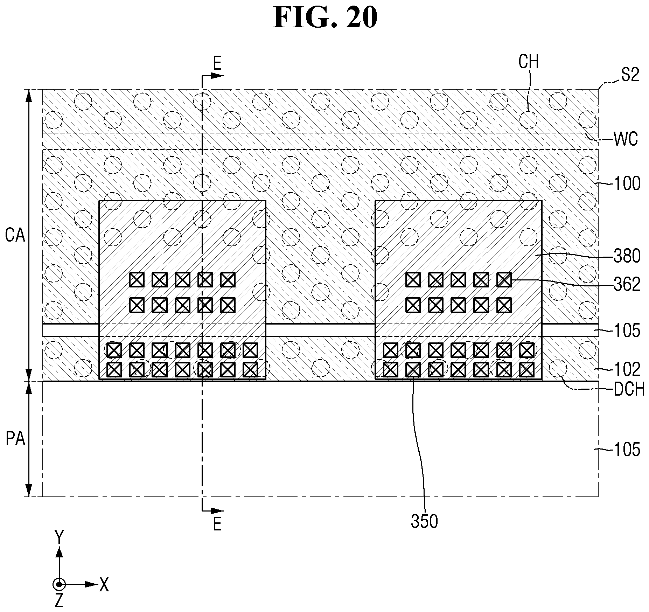

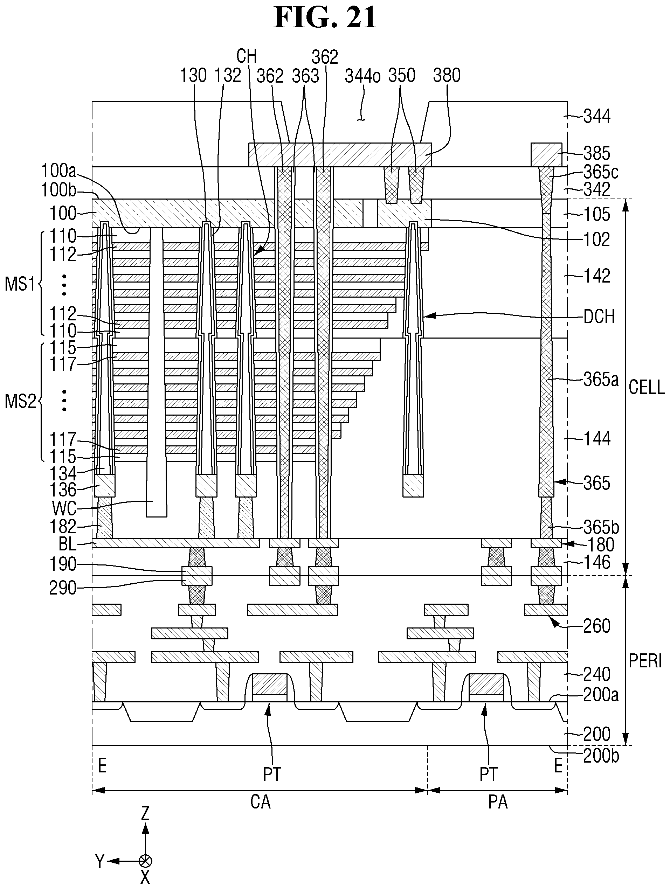

FIG. 19 is a schematic layout diagram for describing the semiconductor memory device according to some embodiments. FIG. 20 is a layout diagram for describing area S2 of FIG. 19. FIG. 21 is a cross-sectional view taken along line E-E of FIG. 20. For convenience of explanation, portions overlapping those described above with reference to FIGS. 1 to 18 will be only briefly described or a description thereof will be omitted.

Referring to FIGS. 19 to 21, in the semiconductor memory device according to some embodiments, the input/output pad 380 completely overlaps the cell array area CA.

For example, the input/output pad 380 may overlap the cell array area CA in the third direction Z, and may not overlap the external area PA in the third direction Z. Specifically, the input/output pad 380 may overlap the cell array area CA when viewed in the third direction Z, and may not overlap the external area PA when viewed in the third direction Z. In some embodiments, as the input/output pad 380 does not overlap the external area PA, the first contact plug 360 described above using FIGS. 3 to 7 may be omitted. In addition, in some embodiments, as an overlapping area between the input/output pad 380 and the cell array area CA is expanded, a greater number of second contact plugs 362 may be provided.

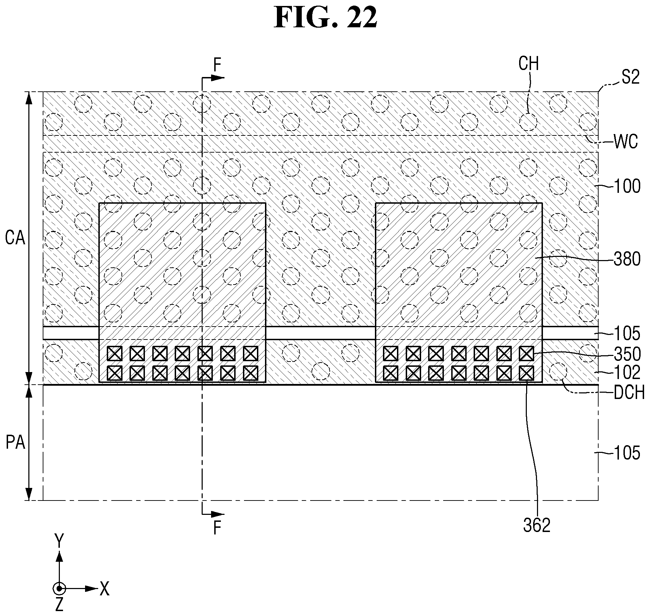

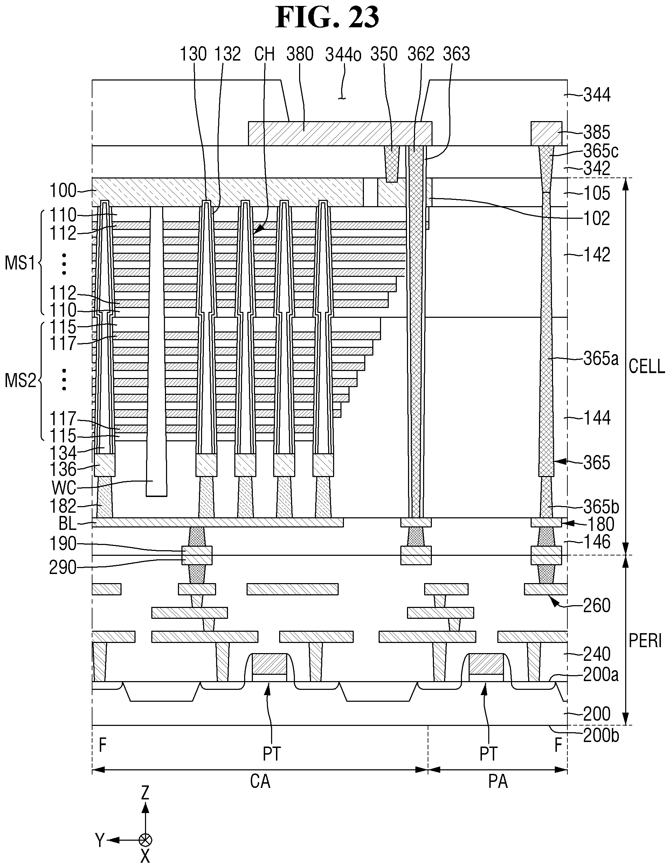

FIG. 22 is a layout diagram for describing a semiconductor memory device according to some embodiments. FIG. 23 is a cross-sectional view taken along line F-F of FIG. 22. For convenience of explanation, portions overlapping those described above with reference to FIGS. 1 to 21 will be only briefly described or a description thereof will be omitted.

Referring to FIGS. 19, 22, and 23, in the semiconductor memory device according to some embodiments, the second contact plug 362 may penetrate through or extend through the landing pattern 102.

For example, the second contact plug 362 may extend in the third direction Z to penetrate through or extend through the interlayer insulating films 142 and 144, the stacked structures MS1 and MS2, the landing pattern 102, and the upper insulating film 342. The input/output pad 380 may be electrically connected to the cell wiring structure 180 through the second contact plug 362.

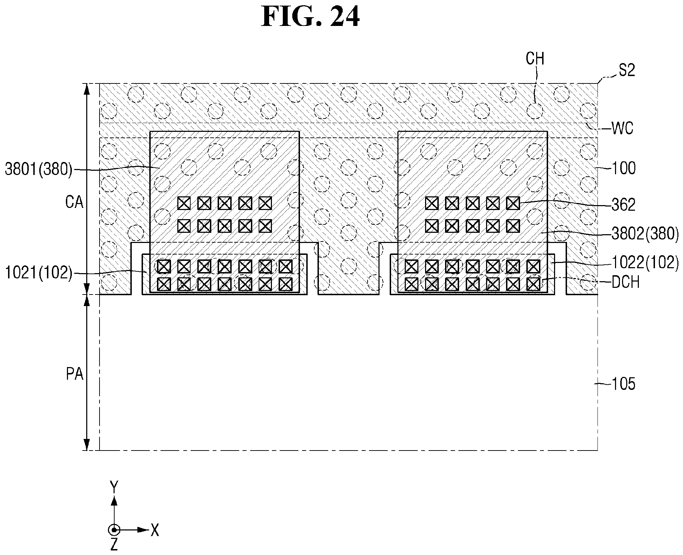

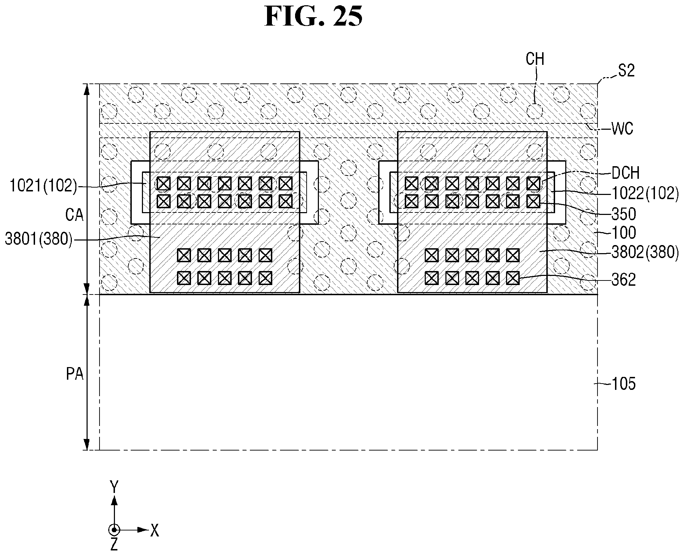

FIGS. 24 and 25 are various layout diagrams for describing a semiconductor memory device according to some embodiments. For convenience of explanation, portions overlapping those described above with reference to FIGS. 1 to 21 will be only briefly described or a description thereof will be omitted.

Referring to FIGS. 19, 24, and 25, in the semiconductor memory device according to some embodiments, the cell substrate 100 surrounds at least a portion of a perimeter of the landing pattern 102 when viewed in a plan view.

For example, the input/output pad 380 may include a first input/output pad 3801 and a second input/output pad 3802 arranged along the first direction X. In addition, for example, the landing pattern 102 may include a first landing pattern 1021 and a second landing pattern 1022 arranged along the first direction X. In this case, the first landing pattern 1021 and the second landing pattern 1022 may each overlap a portion of the cell substrate 100 in the first direction X i.e. the first landing pattern 1021 and the second landing pattern 1022 may each overlap a portion of the cell substrate 100 when viewed in the first direction X. For example, as illustrated in FIG. 24, the cell substrate 100 may surround a portion of the perimeter of the landing pattern 102 when viewed in a plan view. As another example, as illustrated in FIG. 25, the cell substrate 100 may completely surround the perimeter of the landing pattern 102 in plan view.

Hereinafter, a method for fabricating a semiconductor memory device according to some embodiments will be described with reference to FIGS. 1 to 37.

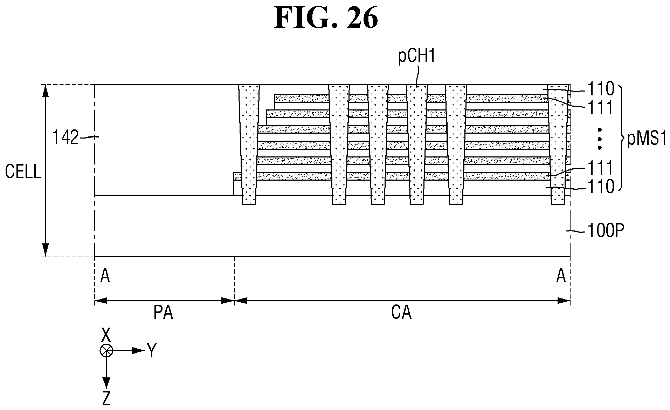

FIGS. 26 to 37 are intermediate step views for describing a method for fabricating a semiconductor memory device according to some embodiments. For convenience of explanation, portions overlapping those described above with reference to FIGS. 1 to 25 will be only briefly described or description thereof will be omitted.

Referring to FIG. 26, a first preliminary mold pMS1 and a first preliminary channel pCH1 are formed on a base substrate 100P.

The first preliminary mold pMS1 may be formed on a cell array area CA of the base substrate 100P. The first preliminary mold pMS1 may include a plurality of first mold insulating films 110 and a plurality of first mold sacrificial films 111 alternately stacked on the base substrate 100P. The first mold sacrificial films 111 may include a material having an etch selectivity with respect to the first mold insulating films 110. For example, each first mold insulating film 110 may include a silicon oxide film, and each first mold sacrificial film 111 may include a silicon nitride film. In some embodiments, the first preliminary mold pMS1 adjacent to the external area PA may be patterned in a stepped shape.

The first preliminary channel pCH1 may extend in the third direction Z and penetrate through or extend through the first preliminary mold pMS1. In some embodiments, the first preliminary channel pCH1 may be connected to the base substrate 100P. A first interlayer insulating film 142 covering the first preliminary mold pMS1 may be formed on the base substrate 100P. The first preliminary channel pCH1 may penetrate through or extend through the first interlayer insulating film 142 and the first preliminary mold pMS1 and be connected to the base substrate 100P.

The first preliminary channel pCH1 may include a material having an etch selectivity with respect to the first mold insulating films 110 and the first mold sacrificial films 111. For example, the first preliminary channel pCH1 may include poly silicon (poly Si).

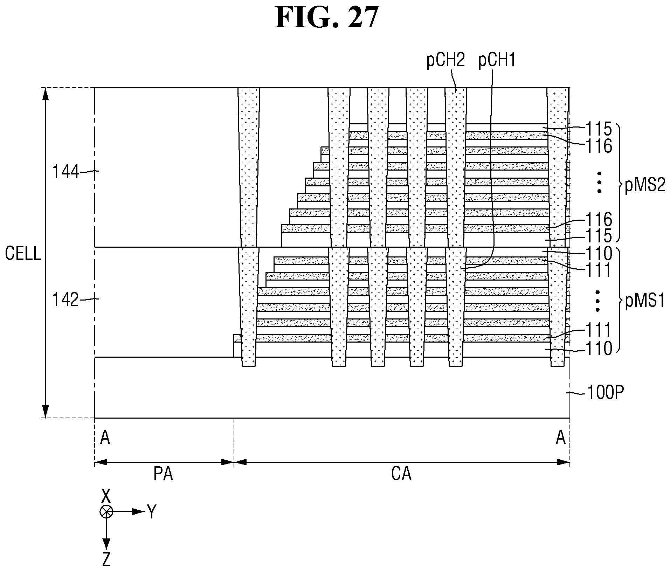

Referring to FIG. 27, a second preliminary mold pMS2 and a second preliminary channel pCH2 are formed on the first preliminary mold pMS1.

The second preliminary mold pMS2 may include a plurality of second mold insulating films 115 and a plurality of second mold sacrificial films 116 alternately stacked on the first preliminary mold pMS1. Since forming the second preliminary mold pMS2 may be similar to forming the first preliminary mold pMS1, a detailed description thereof will be omitted below.

The second preliminary channel pCH2 may extend in the third direction Z and penetrate through or extend through the second preliminary mold pMS2. In addition, the second preliminary channel pCH2 may be connected to the first preliminary channel pCH1. Since forming the second preliminary channel pCH2 may be similar to forming the first preliminary channel pCH1, a detailed description thereof will be omitted below.

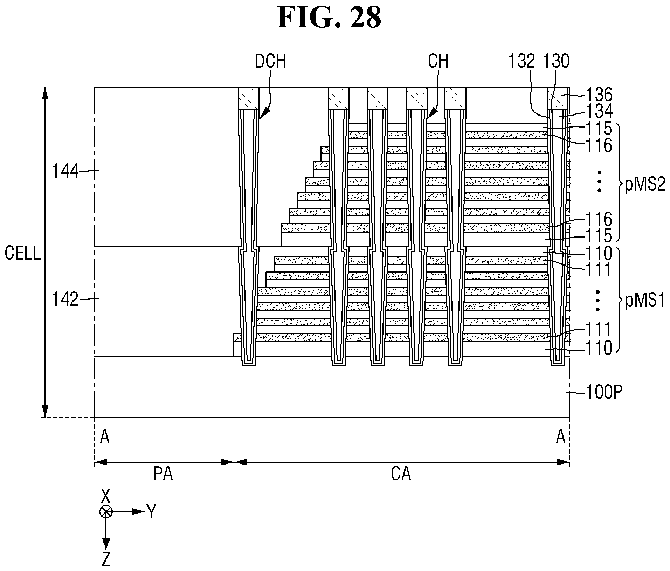

Referring to FIG. 28, a channel structure CH is formed.

For example, the first preliminary channel pCH1 and the second preliminary channel pCH2 may be selectively removed. Subsequently, a channel structure CH may be formed to replace an area from which the first preliminary channel pCH1 and the second preliminary channel pCH2 were present prior to removal thereof. Through this, the channel structure CH extending in the third direction Z and penetrating through or extending through the first preliminary mold pMS1 and the second preliminary mold pMS2 may be formed. In some embodiments, the channel structure CH may include a semiconductor pattern 130, an information storage film 132, a filling insulating film 134, and a channel pad 136.

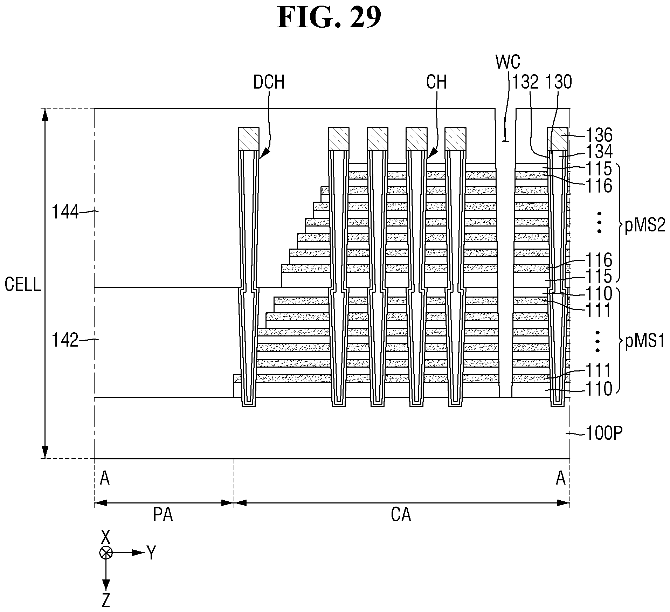

Referring to FIG. 29, a word line cut area WC may be formed.

The word line cut area WC may extend in the first direction X to cut the first preliminary mold pMS1 and the second preliminary mold pMS2.

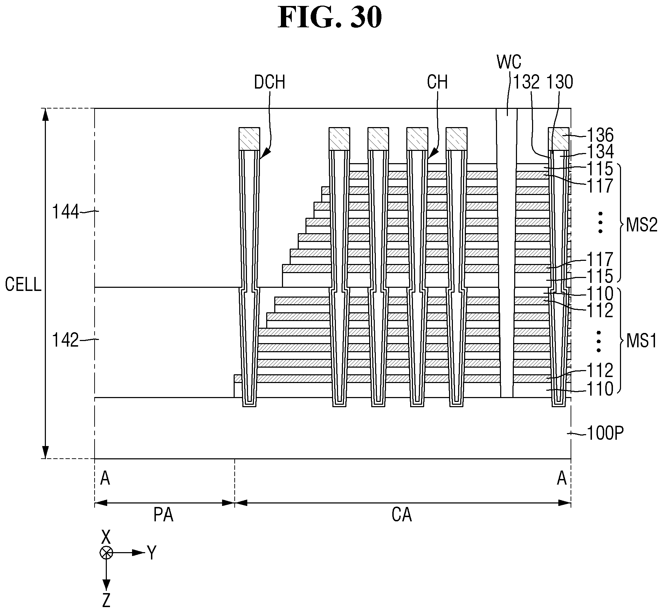

Referring to FIG. 30, a plurality of gate electrodes 112 and 117 are formed.

For example, the mold sacrificial films 111 and 116 exposed by the word line cut area WC may be selectively removed. Subsequently, gate electrodes 112 and 117 may be formed to replace the areas from which the mold sacrificial films 111 and 116 were present prior to removal thereof. Through this, stacked structures MS1 and MS2 including the mold insulating films 110 and 115 and the gate electrodes 112 and 117 may be formed. In some embodiments, after the stacked structures MS1 and MS2 are formed, the word line cut area WC may be filled with an insulating material.

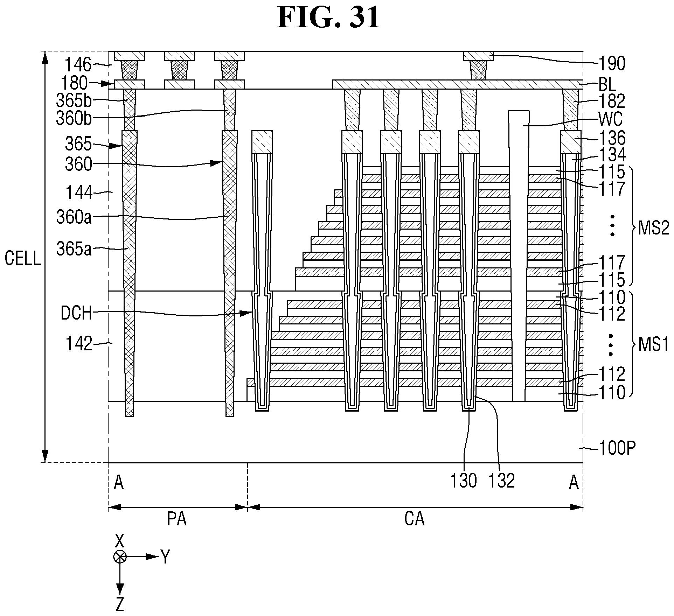

Referring to FIG. 31, a bit line contact 182, a first contact plug 360, an external contact structure 365, a bit line BL, and a cell wiring structure 180 are formed.

The bit line contact 182 may extend in the third direction Z and be connected to the channel structure CH. The first contact plug 360 may extend in the third direction Z and be connected to the base substrate 100P. The external contact structure 365 may be spaced further from the cell array area CA than the first contact plug 360. The bit line BL may be connected to the bit line contact 182 and may extend in the second direction Y. The cell wiring structure 180 may be electrically connected to the bit line BL, the first contact plug 360, and/or the external contact structure 365.

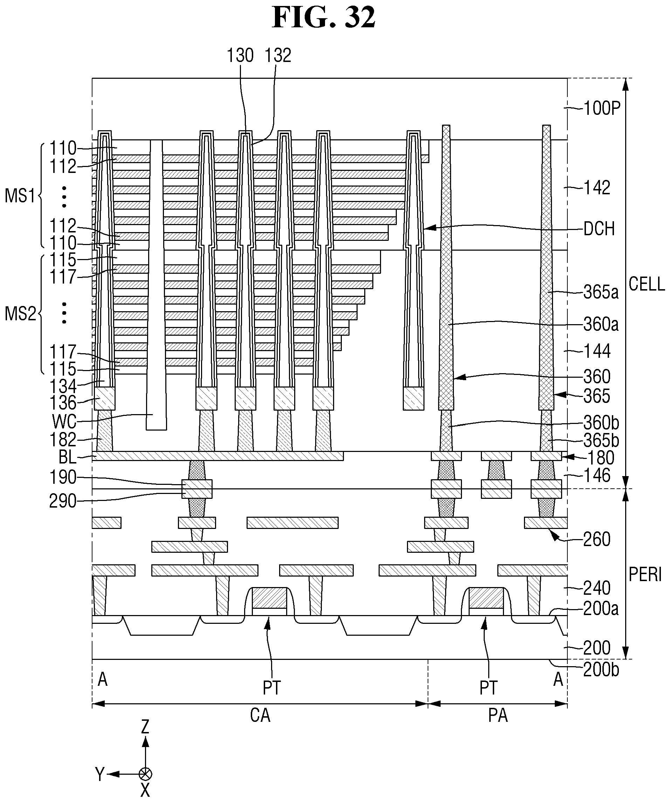

Referring to FIG. 32, a cell structure CELL is stacked on a peripheral circuit structure PERI.

In some embodiments, the cell structure CELL and the peripheral circuit structure PERI may be stacked so that a front side of the base substrate 100P and a front side of the peripheral circuit substrate 200 face each other. For example, the cell wiring structure 180 may be stacked on a peripheral circuit wiring structure 260.

As an example, a first bonding metal 190 formed on the uppermost metal layer of the cell structure CELL and a second bonding metal 290 formed on the uppermost metal layer of the peripheral circuit structure PERI may be bonded. When the first bonding metal 190 and the second bonding metal 290 are formed of copper (Cu), the bonding method may be a Cu-Cu bonding method. However, this is only an example, and the first bonding metal 190 and the second bonding metal 290 may also be formed of various other metals such as aluminum (Al) or tungsten (W).

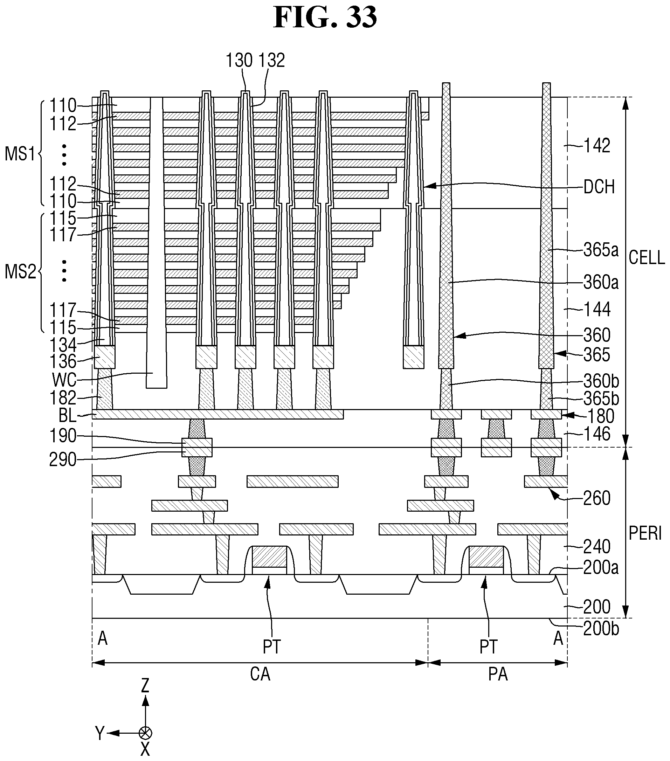

Referring to FIG. 33, one end of the semiconductor pattern 130 is exposed.

For example, a planarization process or a recess process may be performed on a back side of the base substrate 100P. Through this, as at least a portion of the base substrate 100P is removed, one end (e.g., an upper end) of the channel structure CH may be exposed. In addition, a portion of the information storage film 132 of the exposed channel structure CH may be removed. In some exemplary embodiments, one end (e.g., an upper end) of the semiconductor pattern 130 may protrude more than one end of the information storage film 132.

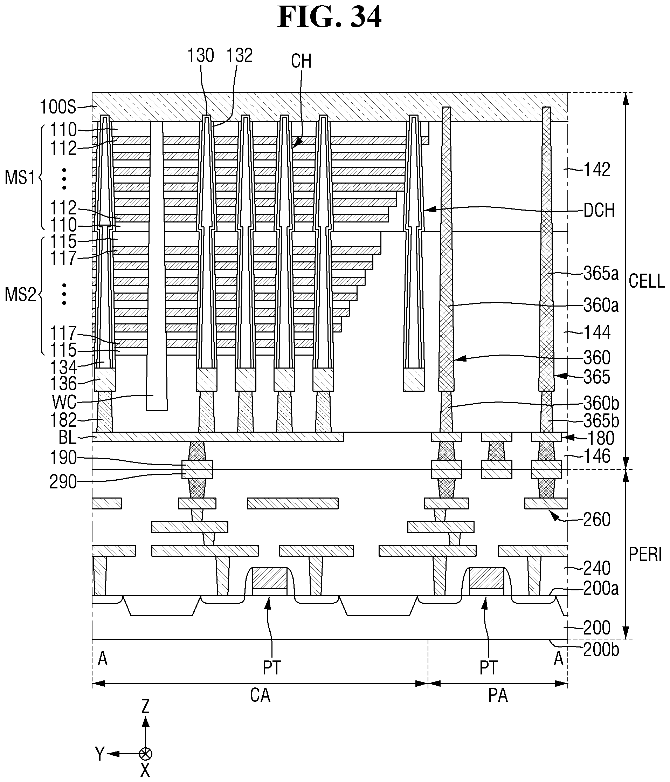

Referring to FIG. 34, a preliminary substrate 100S connected to the semiconductor pattern 130 is formed.

For example, the preliminary substrate 100S may be deposited on a surface of the first preliminary mold pMS1 from which the base substrate 100P has been removed. In some exemplary embodiments, the preliminary substrate 100S may include a conductive material. The conductive material may include, but is not limited to, for example, polysilicon doped with impurities, metal, or metal silicide. As an example, the preliminary substrate 100S may include poly-silicon (poly-Si) doped with N-type impurities (e.g., phosphorus (P), arsenic (As), etc.).

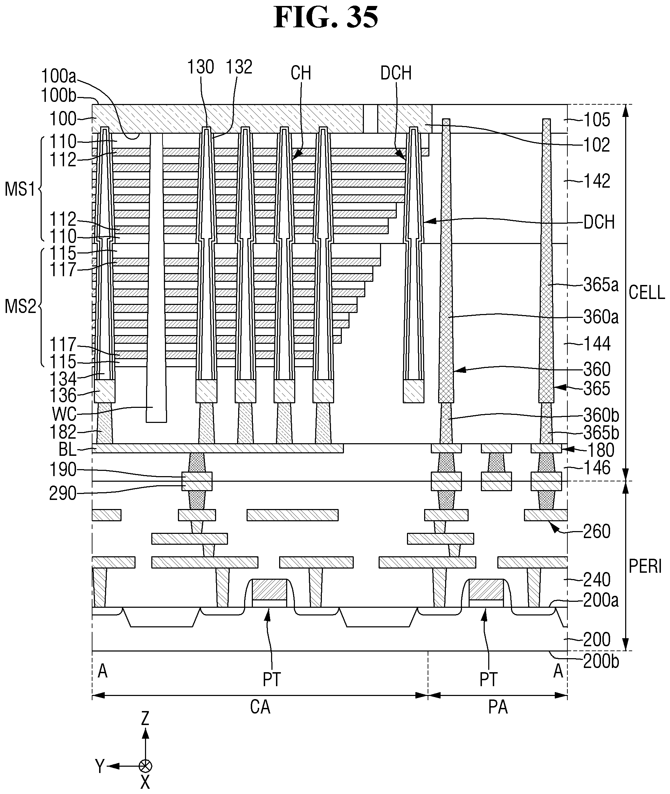

Referring to FIG. 35, a cell substrate 100 and a landing pattern 102 are formed.

For example, the preliminary substrate 100S may be patterned to form the cell substrate 100 and the landing pattern 102 that are spaced apart from each other. Subsequently, an insulating substrate 105 may be formed to fill an area between the cell substrate 100 and the landing pattern 102 and an area on the external area PA. The insulating substrate 105 may electrically separate the cell substrate 100 and the landing pattern 102.

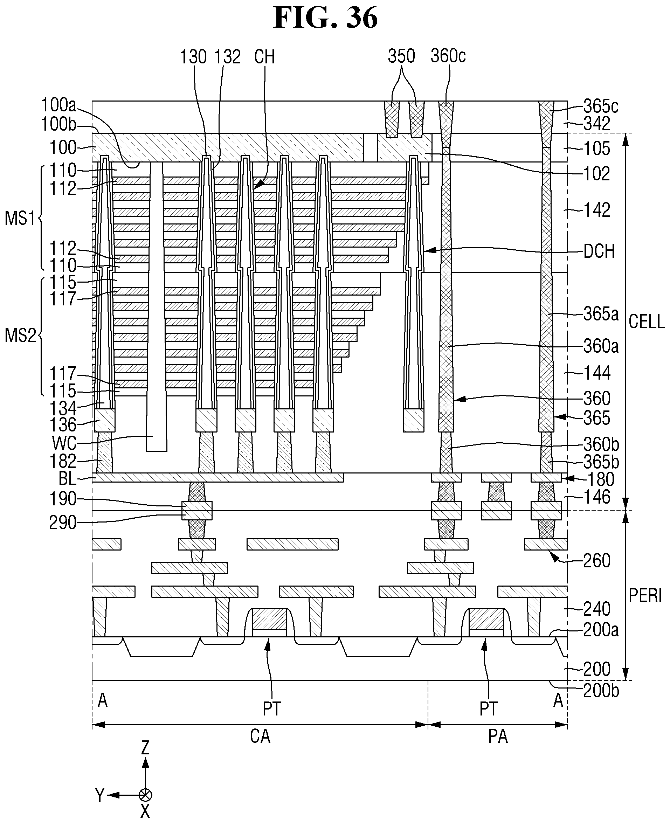

Referring to FIG. 36, an upper insulating film 342 and a support contact 350 are formed.

The upper insulating film 342 may cover the cell substrate 100, the landing pattern 102, and/or the insulating substrate 105. The support contact 350 may penetrate through or extend through the upper insulating film 342 and be connected to the landing pattern 102.

In some embodiments, a third plug pattern 360c and/or a third contact pattern 365c penetrating through or extending through the upper insulating film 342 may be formed. In some embodiments, the support contact 350, third plug pattern 360c, and/or third contact pattern 365c may be formed at the same time or step, or as a result of the same process.

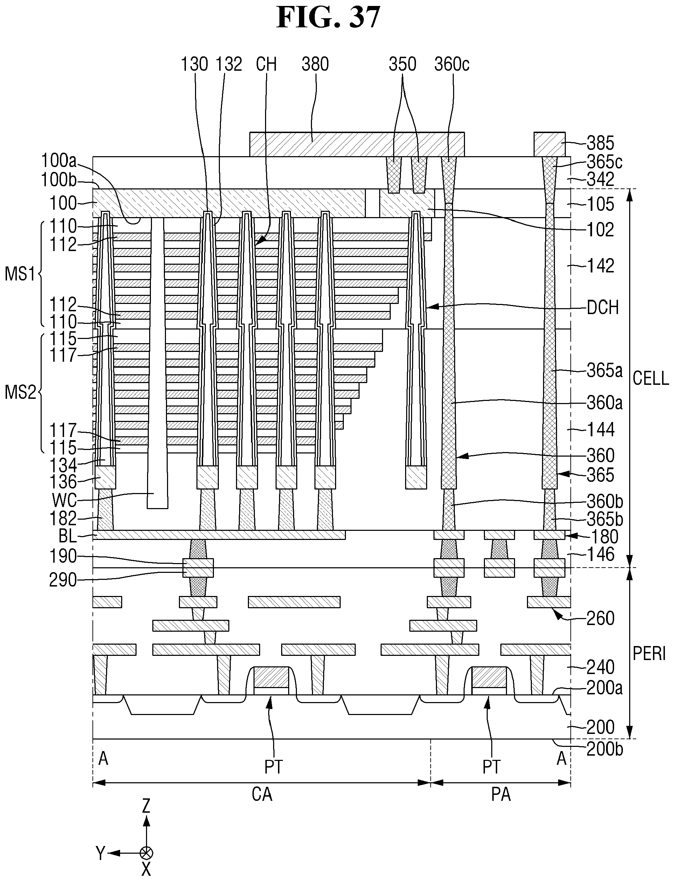

Referring to FIG. 37, an input/output pad 380 is formed on the upper insulating film 342.

The input/output pad 380 may be connected to the support contact 350 and the first contact plug 360.

In some embodiments, an external pad 385 may be formed on the upper insulating film 342. In some embodiments, the input/output pad 380 and the external pad 385 may be formed at the same time or step, or as a result of the same process.

Subsequently, referring to FIG. 5, a capping insulating film 344 is formed on the upper insulating film 342. Through this, the semiconductor memory device described above with reference to FIGS. 3 to 7 may be fabricated.

Hereinafter, an electronic system including the semiconductor memory device according to some embodiments will be described with reference to FIGS. 1 to 40.

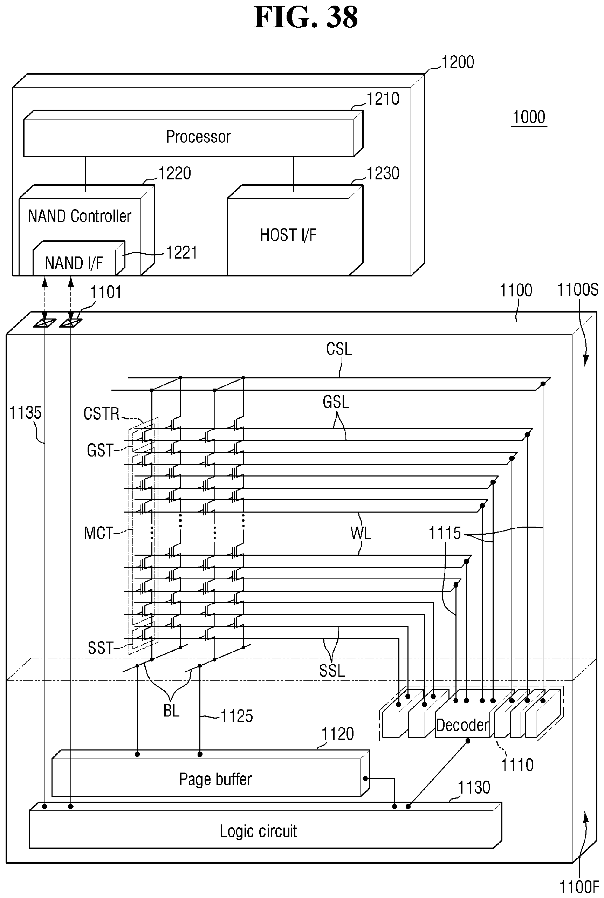

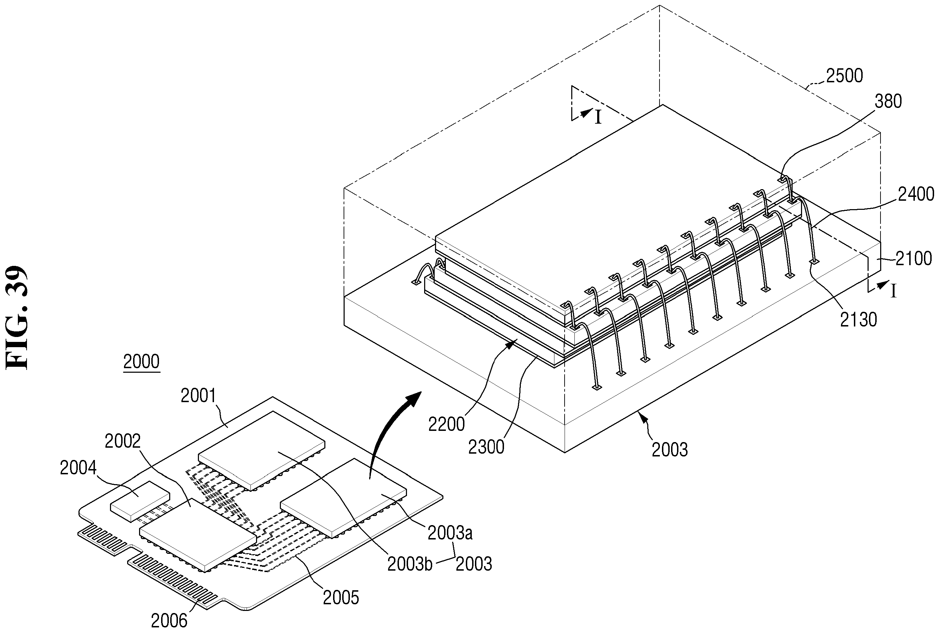

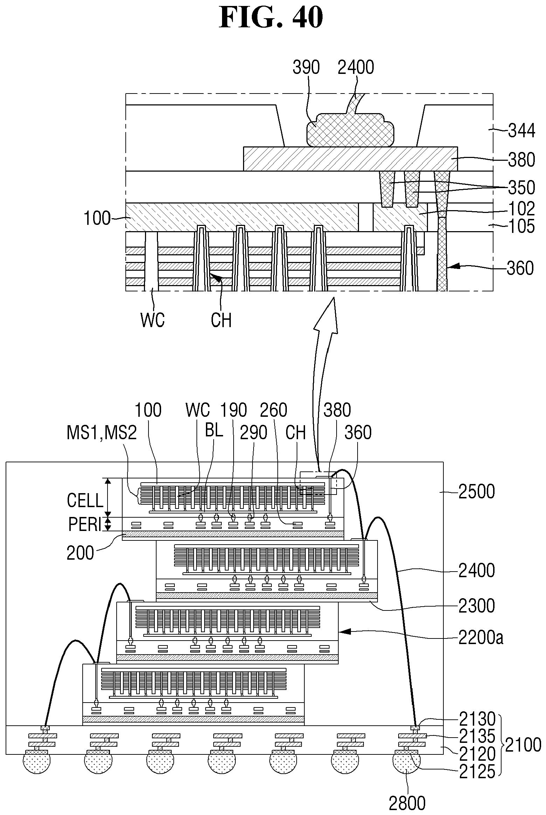

FIG. 38 is an example of a block diagram for describing an electronic system according to some embodiments. FIG. 39 is a perspective view for describing an electronic system according to some embodiments. FIG. 40 is a schematic cross-sectional view taken along line I-I of FIG. 39. For convenience of explanation, portions overlapping those described above with reference to FIGS. 1 to 37 will be only briefly described or a description thereof will be omitted.

Referring to FIG. 38, an electronic system 1000 according to some embodiments may include a semiconductor memory device 1100 and a controller 1200 electrically connected to the semiconductor memory device 1100. The electronic system 1000 may be a storage device including one semiconductor memory device 1100 or a plurality of semiconductor memory devices 1100 or an electronic device including the storage device. For example, the electronic system 1000 may be a solid state drive (SSD) device, a universal serial bus (USB), a computing system, a medical device, or a communication device including one semiconductor memory device 1100 or a plurality of semiconductor memory devices 1100.

The semiconductor memory device 1100 may be a non-volatile memory device (e.g., a NAND flash memory device), and may include, for example, at least one of the semiconductor memory devices described above with reference to FIGS. 1 to 25. The semiconductor memory device 1100 may include a first structure 1100F and a second structure 1100S on the first structure 1100F.

The first structure 1100F may be a peripheral circuit structure including a decoder circuit 1110 (e.g., a row decoder 33 in FIG. 1), a page buffer 1120 (e.g., a page buffer 35 in FIG. 1), and a logic circuit 1130 (e.g., a control logic 37 in FIG. 1). For example, the first structure 1100F may correspond to the peripheral circuit structure PERI described above using FIGS. 1 to 25.

The second structure 1100S may include the common source line CSL, the plurality of bit lines BL, and the plurality of cell strings CSTR described above with reference to FIG. 2. The cell strings CSTR may be connected to the decoder circuit 1110 through the word line WL, at least one string select line SSL, and at least one ground select line GSL. In addition, the cell strings CSTR may be connected to the page buffer 1120 through the bit lines BL. For example, the second structure 11005 may correspond to the cell structure CELL described above using FIGS. 1 to 25.

In some embodiments, the common source line CSL and cell string CSTR may be electrically connected to the decoder circuit 1110 through first connection wirings 1115 extending from the first structure 1100F to the second structure 11005.

In some embodiments, the bit lines BL may be electrically connected to the page buffer 1120 through second connection wirings 1125.

The semiconductor memory device 1100 may communicate with the controller 1200 through an input/output pad 1101 electrically connected to the logic circuit 1130 (e.g., the control logic 37 in FIG. 1). For example, the input/output pad 1101 may correspond to the input/output pad 380 described above using FIGS. 1 to 25. The input/output pad 1101 may be electrically connected to the logic circuit 1130 through an input/output connection wiring 1135 extending from the first structure 1100F to the second structure 1100S. For example, the connection wiring 1135 may correspond to the first contact plug 360 described above using FIGS. 1 to 25.

The controller 1200 may include a processor 1210, a NAND controller 1220, and a host interface 1230. In some embodiments, the electronic system 1000 may include a plurality of semiconductor memory devices 1100, and in this case, the controller 1200 may control the plurality of semiconductor memory devices 1100.

The processor 1210 may control an overall operation of the electronic system 1000 including the controller 1200. The processor 1210 may operate according to predetermined firmware, and may access the semiconductor memory device 1100 by controlling the NAND controller 1220. The NAND controller 1220 may include a NAND interface 1221 that processes communication with the semiconductor memory device 1100. A control command for controlling the semiconductor memory device 1100, data to be written to memory cell transistors MCT of the semiconductor memory device 1100, data to be read from the memory cell transistors MCT of the semiconductor memory device 1100, etc. may be transmitted through the NAND interface 1221. The host interface 1230 may provide a communication function between the electronic system 1000 and an external host. When a control command is received from the external host through the host interface 1230, the processor 1210 may control the semiconductor memory device 1100 in response to the control command.

Referring to FIGS. 39 and 40, an electronic system 2000 according to some embodiments may include a main board 2001, and a main controller 2002, one or more semiconductor packages 2003, and a dynamic random access memory (DRAM) 2004 that are mounted on the main board 2001. The semiconductor package 2003 and the DRAM 2004 may be connected to the main controller 2002 by wiring patterns 2005 formed on the main board 2001.

The main board 2001 may include a connector 2006 including a plurality of pins coupled to the external host. The number and arrangement of the plurality of pins in the connector 2006 may vary depending on a communication interface between the electronic system 2000 and the external host. In some embodiments, the electronic system 2000 may communicate with the external host according to any one of interfaces such as universal serial bus (USB), peripheral component interconnect express (PCI-Express), serial advanced technology attachment (SATA), and M-Phy for universal flash storage (UFS). In some embodiments, the electronic system 2000 may operate by power supplied from the external host through the connector 2006. The electronic system 2000 may further include a power management integrated circuit (PMIC) for distributing the power supplied from the external host to the main controller 2002 and the semiconductor package 2003.

The main controller 2002 may write or read data to or from the semiconductor package 2003, and may improve an operation speed of the electronic system 2000.

The DRAM 2004 may be a buffer memory that may alleviate a speed difference between the semiconductor package 2003, which is a data storage space, and the external host. The DRAM 2004 included in the electronic system 2000 may operate as a kind of cache memory, and may also provide a space for temporarily storing data in a control operation for the semiconductor package 2003. When the electronic system 2000 includes the DRAM 2004, the main controller 2002 may further include a DRAM controller for controlling the DRAM 2004, in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. The first and second semiconductor packages 2003a and 2003b may each include a package substrate 2100, semiconductor chips 2200 on the package substrate 2100, adhesive layers 2300 on a lower surface of each of the semiconductor chips 2200, connection structures 2400 electrically connecting the semiconductor chips 2200 to the package substrate 2100, and a molding layer 2500 covering the semiconductor chips 2200 and the connection structures 2400 on the package substrate 2100.

The package substrate 2100 may be a printed circuit board including package upper pads 2130. Each semiconductor chip 2200 may include an input/output pad 380. The input/output pad 380 may correspond to the input/output pad 1101 of FIG. 38.

In some embodiments, the connection structure 2400 may be a bonding wire electrically connecting the input/output pad 380 to the package upper pads 2130. For example, the connection structure 2400 may be connected to the input/output pad 380 by bonding solder 390. Accordingly, in each of the first and second semiconductor packages 2003a and 2003b, the semiconductor chips 2200 may be electrically connected to each other by a bonding wire method, and be electrically connected to the package upper pads 2130 of the package substrate 2100. In some embodiments, in each of the first and second semiconductor packages 2003a and 2003b, the semiconductor chips 2200 may also be electrically connected to each other by connection structures including through silicon vias (TSVs) instead of the connection structures 2400 of the bonding wire method.

In some embodiments, the main controller 2002 and the semiconductor chips 2200 may also be included in one package. In some embodiments, the main controller 2002 and the semiconductor chips 2200 may be mounted on a separate interposer substrate different from the main board 2001, and the main controller 2002 and the semiconductor chips 2200 may also be connected to each other by wirings formed on the interposer substrate.

In some embodiments, the package substrate 2100 may be a printed circuit board. The package substrate 2100 may include a package substrate body portion 2120, package upper pads 2130 on an upper surface of the package substrate body portion 2120, lower pads 2125 on or exposed through a lower surface of the package substrate body portion 2120, and internal wirings 2135 electrically connecting the package upper pads 2130 and the lower pads 2125 to each other in the package substrate body portion 2120. The upper pads 2130 may be electrically connected to the connection structures 2400. The lower pads 2125 may be connected to the wiring patterns 2005 of the main board 2001 of the electronic system 2000 as illustrated in FIG. 39 through conductive connectors 2800.

In the electronic system according to some exemplary embodiments, each of the semiconductor chips 2200 may include the semiconductor memory device described above with reference to FIGS. 1 to 25. For example, each of the semiconductor chips 2200 may include a cell structure CELL, a peripheral circuit structure PERI, an upper insulating film 342, a support contact 350, and an input/output pad 380. For example, the peripheral circuit structure PERI may include the peripheral circuit substrate 200, the peripheral circuit element PT, and the peripheral circuit wiring structure 260 described above using FIGS. 3 to 7. In addition, for example, the cell structure CELL may include the cell substrate 100, the landing pattern 102, the insulating substrate 105, the stacked structures MS1 and MS2, the channel structure CH, the word line cut area WC, the bit line BL, and the cell wiring structure 180 described above using FIGS. 3 to 7. The peripheral circuit structure PERI and the cell structure CELL may be bonded to each other through a first bonding metal 190 and a second bonding metal 290.

While the present inventive concepts have been particularly shown and described with reference to some examples of embodiments thereof, it will be understood by those of ordinary skill in the art that various changes in form and details may be made therein without departing from the scope of the present inventive concepts as defined by the following claims. It is therefore desired that the embodiments described herein be considered in all respects as illustrative and not restrictive, reference being made to the appended claims rather than the foregoing description to indicate the scope of the inventive concepts.

## Claims

1. A semiconductor memory device (10) comprising:
a cell substrate (100) including a first surface (100a) and a second surface (100b) opposite to the first surface (100a);
a landing pattern (102) including a third surface (102a) and a fourth surface (102b) opposite to the third surface (102a), the landing pattern (102) spaced apart from the cell substrate (100) in a horizontal direction;
a plurality of gate electrodes (112, 117) sequentially stacked on the first surface (100a) and the third surface (102a);
a channel structure (CH) on the cell substrate (100), the channel structure (CH) extending in a vertical direction that intersects the first surface (100a), the channel structure (CH) intersecting the plurality of gate electrodes (112, 117);
an upper insulating film (342) that covers the second surface (100b) and the fourth surface (102b);
an input/output pad (380) on the upper insulating film (342), the input/output pad (380) overlapping at least a portion of the plurality of gate electrodes (112, 117) in the vertical direction; and
a support contact (350) that extends through the upper insulating film (342) and connects the landing pattern (102) and the input/output pad (380).

2. The semiconductor memory device (10) of claim 1, further comprising a contact plug (360) spaced apart from the landing pattern (102) in the horizontal direction, extending in the vertical direction and connected to the input/output pad (380).

3. The semiconductor memory device (10) of claim 2, further comprising:
a peripheral circuit substrate (200) including a fifth surface (200a) that faces the first surface (100a) and the third surface (102a); and
a peripheral circuit element (PT) on the fifth surface (200a),
wherein the contact plug (360) electrically connects the input/output pad (380) and the peripheral circuit element (PT).

4. The semiconductor memory device (10) of any preceding claim, wherein the cell substrate (100) and the landing pattern (102) include the same material.

5. The semiconductor memory device (10) of any preceding claim, wherein the cell substrate (100) and the landing pattern (102) each include polysilicon doped with impurities.

6. The semiconductor memory device (10) of any preceding claim, wherein the first surface (100a) and the third surface (102a) are coplanar, and
wherein the second surface (100b) and the fourth surface (102b) are coplanar.

7. The semiconductor memory device (10) of any preceding claim, wherein a width of the support contact (350) decreases in a direction toward the landing pattern (102).

8. The semiconductor memory device (10) of any preceding claim, wherein a lower surface of the support contact (350) is between the third surface (102a) and the fourth surface (102b).

9. The semiconductor memory device (10) of any preceding claim, wherein a thickness of the upper insulating film (342) is in a range from 300 nm to 1000 nm, inclusive.

10. The semiconductor memory device (10) of any preceding claim, further comprising an insulating substrate (105) between the cell substrate (100) and the landing pattern (102), the insulating substrate (105) electrically separating the cell substrate (100) and the landing pattern (102).

11. The semiconductor memory device (10) of any preceding claim, wherein the channel structure (CH) is connected to the cell substrate (100).

12. The semiconductor memory device (10) of any preceding claim, further comprising a dummy channel structure (DCH) that extends in the vertical direction, overlapping some of the plurality of gate electrodes (112, 117), and connected to the landing pattern (102).

13. An electronic system (2000) comprising:
a main board (2001);
a semiconductor memory device (10) including a peripheral circuit structure (PERI) and a cell structure (CELL) sequentially stacked on the main board (2001); and
a controller (2002) on the main board (2001), the controller (2002) electrically connected to the semiconductor memory device (10),
wherein the cell structure (CELL) includes:
a cell substrate (100) including a first surface (100a) and a second surface (100b) opposite to the first surface (100a);
a landing pattern (102) including a third surface (102a) and a fourth surface (102b) opposite to the third surface (102a), the landing pattern (102) spaced apart from the cell substrate (100) in a horizontal direction;
a plurality of gate electrodes (112, 117) sequentially stacked on the first surface (100a) and the third surface (102a);
a channel structure (CH) on the cell substrate (100), the channel structure (CH) extending in a vertical direction that intersects the first surface (100a), the channel structure (CH) intersecting the plurality of gate electrodes (112, 117),
an upper insulating film (342) that covers the second surface (100b) and the fourth surface (102b),
an input/output pad (380) on the upper insulating film (342), the input/output pad (380) overlapping at least a portion of the plurality of gate electrodes (112, 117) in the vertical direction and electrically connected to the controller (2002), and
a support contact (350) that extends through the upper insulating film (342) and connects the landing pattern (102) with the input/output pad (380).

14. The electronic system (2000) of claim 13, further comprising a contact plug (360) spaced apart from the landing pattern (102) and extending in the vertical direction, the contact plug (360) electrically connecting the peripheral circuit structure (PERI) and the input/output pad (380).

15. The electronic system (2000) of claim 13 or 14, further comprising:
a package substrate (2100) on the main board (2001), electrically connected to the controller (2002);
a plurality of semiconductor chips (2200) stacked on the package substrate (2100), each of the plurality of semiconductor chips (2200) including the semiconductor memory device (10); and
a connection structure (2400) electrically connecting the input/output pad (380) of each of the semiconductor chips (2200) and the package substrate (2100).
